# EUROPEAN PATENT SPECIFICATION

(11) **EP 3 564 690 B1**
(45) Date of publication and mention of the grant of the patent: **01.07.2020**
(21) Application number: 18170564.1
(22) Date of filing: 03.05.2018
(51) Int. Cl.: G01R 31/08, H01B 7/06, H01B 7/32

(54) **A CABLE ASSEMBLY**
KABELANORDNUNG
ENSEMBLE DE CÂBLE

(43) Date of publication of application: 06.11.2019
(73) Proprietor: ETH Zurich, 8092 Zurich (CH)
(72) Inventor: LIBERATO ELIAS, Edi, 11900-000 Registro-SP (BR); MARTINEZ, Vincent, 8049 Zurich (CH); HIRT, Luca, 4600 Olten (CH); WEYDERT, Serge, 8006 Zürich (CH); HIRT, Walter, 8196 Wil (CH); VÖRÖS, Janos, 8050 Zurich (CH)
(74) Representative: P&TS SA (AG, Ltd.)

(56) References cited:
- CN-A- 101 149 865
- CN-A- 103 065 420
- DE-A1- 3 942 487
- US-A- 4 859 989
- US-A1- 2010 122 832

## Description

### Field of the invention

The present invention concerns a cable assembly, and in particular a cable assembly comprising, a main lead and an auxiliary lead which are connected in series, the main lead having a wire surrounded by an electrically conductive sheath; wherein the main lead and an auxiliary lead can be connected to a measurement circuit which can determine the integrity of the main lead based on electrical properties of the main lead and/or auxiliary lead.

### Description of related art

Cables generally include one or more electrically conductive wires; these wires often break leading to cable failure. Cables used in applications where they are under repeated mechanical stress, are particularly vulnerable to this problem. In particular the failure of a cable can occur abruptly and without announcement and can thus lead to expensive machine downtime and/or dangerous situations, e.g. in medical applications.

CN103065420 discloses an unrecoverable cable-type linear heat fire detector and an alarm method of the unrecoverable cable-type linear heat fire detector. The heat fire detector comprises a temperature sensing cable and a signal processing unit which is connected with one end of the temperature sensing cable, wherein the temperature sensing cable comprises two detecting conductors which are stranded together, and a temperature sensing insulation layer is arranged between the two detecting conductors. The temperature sensing insulation layer is made of negative-temperature-coefficient polymer insulation materials or positive temperature-coefficient polymer insulation materials or negative temperature-coefficient polymer insulation materials with a resistance abrupt change property. The unrecoverable cable-type linear heat fire detector can realize temperature detection through the change of resistance of the temperature sensing insulation layer in the unrecoverable cable-type linear heat fire detector, in combination with the inherent softening characteristic of the materials of the temperature sensing insulation layer, a short circuit is enabled to happen between the cores of the cable to achieve a temperature rising limit alarm effect, and therefore an abnormal failure short circuit and the temperature rising limit alarm short circuit can be distinguished, detection sensitivity of the temperature sensing cable is enhanced, and response time is shortened.

It is an aim of the present invention to obviate or mitigate at least some of the disadvantages associated with existing solutions in the field. In particular it is an aim of the present invention to provide a cable assembly which allows a break in a wire of the cable to be detected, and which maintains the cable as functional in the event of a break occurring in the wire, thereby allowing the replacement of a cable with a broken wire before complete failure of the cable.

### Brief summary of the invention

According to the invention, these aims are achieved by means of a cable assembly comprising the features recited in independent claim 1.

Preferably the at least one main lead and at least one auxiliary lead are connected in series. Most preferably by having the first end of the second electrically conductive wire being connected to the first end portion of the first electrically conductive wire at a first node, achieves that the at least one main lead and the at least one auxiliary lead are connected in series.

The first electrically conductive sheath preferably comprises a conductive composite material. Preferably the conductive composite material has a resistivity which is smaller than 10^-2 Ωm and greater than 3*10^-7 Ωm.

In the present invention, if a break occurs in the first electrically conductive wire of the main lead (i.e. the first electrically conductive wire of the main lead breaks into two pieces, forming a first wire segment and second wire segment which are mechanically separated), the conductive sheath will maintain electrical connection between the two wire segments; electric current can flow from one wire segment, through the first electrically conductive sheath, and into the second wire segment. Accordingly the cable will continue to be functional despite a break in the first electrically conductive wire.

second electrically conductive wire being connected to the first end portion of the first electrically conductive wire at a first node, achieves that the at least one main lead and the at least one auxiliary lead are connected in series.

The first electrically conductive sheath preferably comprises a conductive composite material. Preferably the conductive composite material has a resistivity which is smaller than 10^-2 Ωm and greater than 3*10^-7 Ωm.

In the present invention, if a break occurs in the first electrically conductive wire of the main lead (i.e. the first electrically conductive wire of the main lead breaks into two pieces, forming a first wire segment and second wire segment which are mechanically separated), the conductive sheath will maintain electrical connection between the two wire segments; electric current can flow from one wire segment, through the first electrically conductive sheath, and into the second wire segment. Accordingly the cable will continue to be functional despite a break in the first electrically conductive wire.

The break in the first electrically conductive wire of the main lead will result in a change in the resistance of the main lead; this change in resistance can be detected by connecting a measurement circuit to both main lead and the auxiliary lead and measuring (using the measurement circuit) for a change in resistance of the main lead.

Preferably said main lead and said auxiliary lead are arranged to be side-by-side along the majority of the length of the main lead and auxiliary lead. Most preferably the main lead and said auxiliary lead are arranged to be substantially parallel along the majority of the length of the main lead and auxiliary lead.

Preferably the main lead and the auxiliary lead are configured to be flexible.

Most preferably the first electrically conducting sheath comprises a matrix, and a plurality of electrically conductive elements at least some of which are both partially embedded in the matrix and are in mechanical and electrical contact with said first electrically conductive wire, and wherein said plurality of electrically conductive elements are electrically connected to one another within the matrix. Said matrix preferably comprises a polymer material or an elastomer material or a thermoplastic elastomer material. However, it will be understood that the matrix may comprise any other suitable material, such as silicone rubber, polydimethylsiloxane, polyisoprene, styrene butadiene rubber, ethylene propylene diene monomer rubber, polychloroprene rubber, chlorosulfonyl polyethylene rubber, acrylonitrile butadiene rubber, polyacrylic rubber, ethylene acrylic rubber, epichlorohydrin rubber, polyisobutylene rubber, hydrogenated nitrile rubber, fluorocarbon rubber, fluorosilicone rubber, perfluorocarbon rubber, thermoplastic polyurethane, styrenic block copolymers, thermoplastic olefins, elastomeric alloys, thermoplastic copolyester, and/or thermoplastic polyamide, for example. Said electrically conductive elements may comprise copper (e.g. copper microparticles or copper nanoparticles), silver (e.g. silver microparticles or silver nanoparticles), nano-wires, microparticles (e.g. metallic microparticles), nanotubes (e.g. carbon nanotubes), flakes (e.g. metallic flakes), and/or graphene. It will also be understood that the electrically conductive elements may comprise any electrically conductive material; for example the electrically conductive elements may comprise any one or more of, copper microparticles, aluminum microparticles, gold microparticles, tin microparticles, copper nanowires, silver nanowires, aluminum nanowires, gold nanowires, tin nanowires, copper flakes, silver flakes, aluminum flakes, gold flakes, tin flakes, carbon particles, carbon nanotubes, graphene.

In the cable assembly according to an aspect of the invention the second electrically conductive wire of the auxiliary lead has a second electrically conductive sheath.

Most preferably the second electrically conducting sheath comprises a matrix, and a plurality of electrically conductive elements at least some of which are both partially embedded in the matrix and are in mechanical and electrical contact with said second electrically conductive wire, and wherein said plurality of electrically conductive elements are electrically connected to one another within the matrix. Said matrix preferably comprises a polymer material or an elastomer material or a thermoplastic elastomer material. However, it will be understood that the matrix may comprise any other suitable material, such as silicone rubber, polydimethylsiloxane, polyisoprene, styrene butadiene rubber, ethylene propylene diene monomer rubber, polychloroprene rubber, chlorosulfonyl polyethylene rubber, acrylonitrile butadiene rubber, polyacrylic rubber, ethylene acrylic rubber, epichlorohydrin rubber, polyisobutylene rubber, hydrogenated nitrile rubber, fluorocarbon rubber, fluorosilicone rubber, perfluorocarbon rubber, thermoplastic polyurethane, styrenic block copolymers, thermoplastic olefins, elastomeric alloys, thermoplastic copolyester, and/or thermoplastic polyamide, for example. Said electrically conductive elements may comprise silver (e.g. silver microparticles or silver nanoparticles), copper (e.g. copper microparticles or copper nanoparticles), nano-wires, microparticles (e.g. metallic microparticles), nanotubes (e.g. carbon nanotubes), flakes (e.g. metallic flakes), and/or graphene. It will also be understood that the electrically conductive elements may comprise any electrically conductive material; for example the electrically conductive elements may comprise any one or more of, copper microparticles, aluminum microparticles, gold microparticles, tin microparticles, copper nanowires, silver nanowires, aluminum nanowires, gold nanowires, tin nanowires, copper flakes, silver flakes, aluminum flakes, gold flakes, tin flakes, carbon particles, carbon nanotubes, graphene.

The second electrically conductive sheath has a second predefined resistance. According to an aspect of the invention the second predefined resistance is different to the first predefined resistance. The first predefined resistance may be influenced by providing a selected density of said electrically conductive elements in the first electrically conductive sheath, and/or by providing a selected thickness of the first electrically conductive sheath. Likewise, the second predefined resistance may be influenced by providing a selected density of said electrically conductive elements in the second electrically conductive sheath, and/or by providing a selected thickness of the second electrically conductive sheath.

In one embodiment, the second predefined resistance differs from the first predefined resistance by more than 10% but no more than 20%. In another embodiment, the second predefined resistance differs from the first predefined resistance by less than 5%. In another embodiment, the second predefined resistance differs from the first predefined resistance by more than 20% but no more than 50%. In another embodiment, the second predefined resistance differs from the first predefined resistance by more than 20%.

In one embodiment, the resistivity of the first electrically conductive sheath is smaller than 10⁻⁵ Ωm and greater than 10⁻⁶ Ωm, and the resistivity of the second electrically conductive sheath is greater than 10⁻⁵ Ωm. In another embodiment, the resistivity of the first electrically conductive sheath is smaller than 10⁻⁵ Ωm and greater than 10⁻⁶ Ωm, and the resistivity of the second electrically conductive sheath is smaller than 10⁻⁵ Ωm and greater than 10⁻⁵ Ωm.In another embodiment, the resistivity of the first electrically conductive sheath is smaller than 10⁻⁶ Ωm.

In an embodiment the density of the electrically conductive elements in the matrix of the first electrically conductive sheath is larger than the density of the electrically conductive elements in the matrix of the second electrically conductive sheath. This ensures that the first predefined resistance is smaller than the second predefined resistance. In another embodiment the density of the electrically conductive elements in the matrix of the first electrically conductive sheath is smaller than the density of the electrically conductive elements in the matrix of the second electrically conductive sheath. This ensures that the first predefined resistance is greater than the second predefined resistance.

The cable assembly may further comprise an insulating jacket. Most preferably the insulating jacket is configured to be flexible.

In the preferred embodiment the main lead and auxiliary lead share a common insulating jacket. In other words a single insulating jacket is provided and both the main lead and auxiliary lead are housed within the single insulating jacket. In another embodiment the main lead comprises a first insulating jacket, and the auxiliary lead comprises a second insulating jacket.

In an embodiment the main lead and/or auxiliary lead further comprise an insulating sheath.

The cable assembly further comprises a measurement circuit, the measurement circuit comprising,
an electronic testing module, wherein the second end portion of the first electrically conductive wire is connected to the electronic testing module at a second node and the second end portion of the second electrically conductive wire is connected to the electronic testing module at a third node;
a memory which stores at least a first predefined threshold resistance value (R1_{threshold});
a processor, which is operably connected to the electronic testing module so that the processor can receive electrical parameters from the electronic testing module, and wherein the processor is further operably connected to the memory so that the processor can receive said stored at least a first predefined threshold resistance value (R1_{threshold}) from the memory,
and wherein the processor is configured to calculate a resistance (R_{measured}) of the main lead and auxiliary lead, between the second and third nodes, using the received electrical parameters;
and wherein the processor is further configured to compare the measured resistance (R_{measured}) with the first predefined threshold resistance value (R1_{threshold}) and preferably to output an alarm if the measured resistance (R_{measured}) is greater than the threshold resistance value (R1_{threshold}).

In another embodiment, the processor of the measurement circuit may be configured to calculate a resistance (R_{measured}) of the main lead only, between the first and third nodes, using the received electrical parameters; and wherein the processor is further configured to compare the measured resistance (R_{measured}) with the first predefined threshold resistance value (R1_{threshold}) and to output an alarm if the measured resistance (R_{measured}) is greater than the threshold resistance value (R1_{threshold}). For example in one embodiment of the cable assembly, wherein the first end portion of the main lead is connected to an external circuit which can supply current to the first end portion of the main lead, and wherein the cable assembly further comprises a measurement circuit, the measurement circuit comprising, an electronic testing module, wherein the second end portion of the second electrically conductive wire is connected to the electronic testing module at a second node, and the second end portion of the first electrically conductive wire is connected to the electronic testing module at a third node ;a memory which stores at least a first predefined threshold resistance value (R1_{threshold}); a processor, which is operably connected to the electronic testing module so that the processor can receive electrical parameters from said electronic testing module, and wherein the processor is further operably connected to the memory so that the processor can receive said stored at least a first predefined threshold resistance value (R1_{threshold}) from the memory, and wherein the processor is configured to calculate a resistance (R_{measured}) of the main lead, between the first node and the third node, using the received electrical parameters; and wherein the processor is further configured to compare the measured resistance (R_{measured}) with the first predefined threshold resistance value (R1_{threshold}) and to output an alarm if the measured resistance (R_{measured}) is greater than the threshold resistance value (R1_{threshold}).

It should be understood that the alarm may take any suitable form. For example the alarm may be a digital signal, which is output by the processor, the digital signal giving information about the integrity/health status of the main lead.

The electronic testing module may comprise,
a voltage source arranged such that it can apply a voltage across the main lead and auxiliary lead;
and a current measurement means arranged to measure current which flows into the third node;
and wherein said electrical parameters comprise the voltage applied by the voltage source across the main lead and auxiliary lead, and the current measured by the current measurement means.

The electronic testing module may comprise,
a current source which is arranged such that it can supply a current to the third node;
and a voltage measurement means arranged to measure a voltage between the second and third nodes;
and wherein said electrical parameters comprise the current supplied by the current source, and the voltage measured by the voltage measurement means.

The electronic testing module may comprise,
a current measurement means arranged to measure current which flows into the third node;
and a voltage measurement means arranged to measure a voltage between the second and third nodes;
and wherein said electrical parameters comprise the current measured by the current measurement means, and the voltage measured by the voltage measurement means.

The processor may be further configured to issue an alarm signal if the current measurement (I_{measured}) taken by the current measurement means indicates that there is no current flowing through the third node.

The processor may be configured to determine if the voltage measured by the voltage measurement means is a floating voltage. This solves the problem that the voltage measurement means cannot determine a correct voltage if there is a complete interruption in the main lead and/or the auxiliary lead.

The measurement circuit may further comprise a main lead contact which is electrically connected to the second node;
wherein the measurement circuit may further comprise a first switch which is connected in series with the electronic testing module between the third node and electronic testing module; and
wherein the measurement circuit may further comprise a second switch between the third node and the main lead contact; and wherein the second switch is connected in parallel with the first switch.

The memory further stores a second predefined threshold resistance value (R2_{threshold}), and a first predefined resistance change (R_{inc1}) and a second predefined resistance change (R_{inc2}). The processor is further configured to, compare the resistance measured (R_{measured}) by the resistance measurement means with the second predefined threshold resistance value (R2_{threshold}) if the resistance measured (R_{measured}) by the resistance measurement means is greater than the first predefined threshold resistance value (R1_{threshold}); and the processor may be further configured to issue a first alarm, and to adjust the value of the first predefined threshold resistance value (R1_{threshold}) stored in the memory to be equal to the resistance measured (R_{measured}) plus the first predefined resistance change (R_{inc1}), and to adjust value of the second predefined threshold resistance value (R2_{threshold}) stored in the memory to be equal to the resistance measured (R_{measured}) plus the second predefined resistance change (R_{inc2}), if the resistance measured (R_{measured}) by the resistance measurement means is smaller than the second predefined threshold resistance value (R2_{threshold}); and wherein the processor may be further configured to issue a second alarm if the resistance measured (R_{measured}) by the resistance measurement means is greater than the second predefined threshold resistance value (R2_{threshold}).

In the cable assembly according to an aspect of the invention, the second electrically conductive wire has a second electrically conductive sheath. The second electrically conductive sheath is configured to have a second predefined resistance, wherein the first predefined resistance is different to the second predefined resistance.

The memory further stores a second predefined threshold resistance value (R2_{threshold}), a third predefined threshold resistance value (R3_{threshold}), and a first predefined resistance change (R_{inc1}) and a second predefined resistance change (R_{inc2}). The processor is further configured to, compare the resistance measured (R_{measured}) by the resistance measurement means with the second predefined threshold resistance value (R2_{threshold}) if the resistance measured (R_{measured}) by the resistance measurement means is greater than the first predefined threshold resistance value (R1_{threshold}). The processor may be further configured to issue a first alarm, and to adjust the value of the first predefined threshold resistance value (R1_{threshold}) stored in the memory to be equal to the resistance measured (R_{measured}) plus the first predefined resistance change (R_{inc1}), and to adjust the value of the second predefined threshold resistance value (R2_{threshold}) stored in the memory to be equal to the resistance measured (R_{measured}) plus the second predefined resistance change (R_{inc2}), if the resistance measured (R_{measured}) by the resistance measurement means is smaller than the second predefined threshold resistance value (R2_{threshold}). The processor is further configured to, compare the resistance measured (R_{measured}) by the resistance measurement means with the third predefined threshold resistance value (R3_{threshold}) if the resistance measured (R_{measured}) by the resistance measurement means is greater than the second predefined threshold resistance value (R2_{threshold}). The processor may be further configured to issue a second alarm, and to adjust value of the first predefined threshold resistance value (R1_{threshold}) stored in the memory to be equal to the resistance measured (R_{measured}) plus the first predefined resistance change (R_{inc1}), and to adjust the value of the second predefined threshold resistance value (R2_{threshold}) stored in the memory to be equal to the resistance measured (R_{measured}) plus the second predefined resistance change (R_{inc2}), if the resistance measured (R_{measured}) by the resistance measurement means is smaller than the third predefined threshold resistance value (R3_{threshold}). The processor may be further configured to issue a third alarm if the resistance measured (R_{measured}) by the resistance measurement means is greater than the third predefined threshold resistance value (R3_{threshold}).

A cable assembly may further comprise,
a first plug member,
a second plug member,
wherein the first electrically conductive wire extends between first plug member and the second plug member, a first end portion of said first electrically conductive wire is connected to a first electrical contact of the first plug member and a second, opposite, end portion of said first electrically conductive wire is connected to a first electrical contact of the second plug member, so that said first electrically conductive wire electrically connects the first and second plug members;
and wherein the first node is housed within the first plug; and wherein the second electrically conductive wire extends from the first node to the second plug member.

Most preferably the first and second plug members each comprise a rigid housing. This can be achieved by forming the housing of the first and second plug member from rigid material.

In an embodiment the measurement circuit is housed within the second plug member. Preferably in this embodiment the second end of the main lead and the second end of the auxiliary lead are connected to the measurement circuit within the second plug member. An output of the processor is connected to an electrical contact of the second plug member. The first electrically conductive wire of the main lead is preferably electrically connected, or selectively electrically connected, to another electrical contact of the second plug member.

In an embodiment a second opposite end of the second electrically conductive wire is connected to a second electrical contact of the second plug member. Preferably in this embodiment the measurement circuit is external to the second plug member and the second plug member can be selectively arranged to be plugged into the measurement circuit so as to electrically connect the main lead and auxiliary lead to the measurement circuit.

### Brief Description of the Drawings

The invention will be better understood with the aid of the description of an embodiment given by way of example and illustrated by the figures, in which:
Figure 1a shows a longitudinal section view of an exemplary cable assembly; Figure 1b shows a cross sectional view of the cable assembly taken along line A-A' of Figure 1a;
Figure 2 shows a longitudinal section view of another exemplary cable assembly;
Figures 3a-e illustrate different possible configurations for the measurement circuit used in any of the cable assemblies of the present invention;
Figure 4 shows a longitudinal section view of a cable assembly according to an aspect of the present invention;
Figure 5 shows a longitudinal section view of a cable assembly according to an aspect of the present invention;
Figure 6 shows a longitudinal section view of a cable assembly according to an aspect of the present invention;
Figure 7a shows a longitudinal section view of a cable assembly according to an aspect of the present invention;
Figure 7b shows a cross sectional view of the cable assembly taken along line A-A' of Figure 7a;
Figure 7c shows a longitudinal section view of a cable assembly according to a further embodiment of the present invention;
Figure 8 shows a longitudinal section view of a cable assembly according to a further embodiment of the present invention;
Figure 9 shows a longitudinal section view of a cable assembly according to a further embodiment of the present invention;
Figure 10 shows a longitudinal section view of a cable assembly according to a further embodiment of the present invention;
Figure 11 shows a longitudinal section view of a cable assembly according to a further embodiment of the present invention;
Figure 12 shows a longitudinal section view of a cable assembly according to a further embodiment of the present invention;
Figure 13 shows a longitudinal section view of a cable assembly according to a further embodiment of the present invention.
Figure 14 shows a longitudinal section view of a cable assembly according to an aspect of the present invention.
Figure 15 illustrate a possible configuration for the measurement circuit used in the cable assembly 1000 shown in Figure 14;
Figure 16 shows a longitudinal section view of a cable assembly according to an aspect of the present invention.
Figure 17 illustrate a possible configuration for the measurement circuit used in the cable assembly 1200 shown in Figure 16;

### Detailed Description of possible embodiments of the Invention

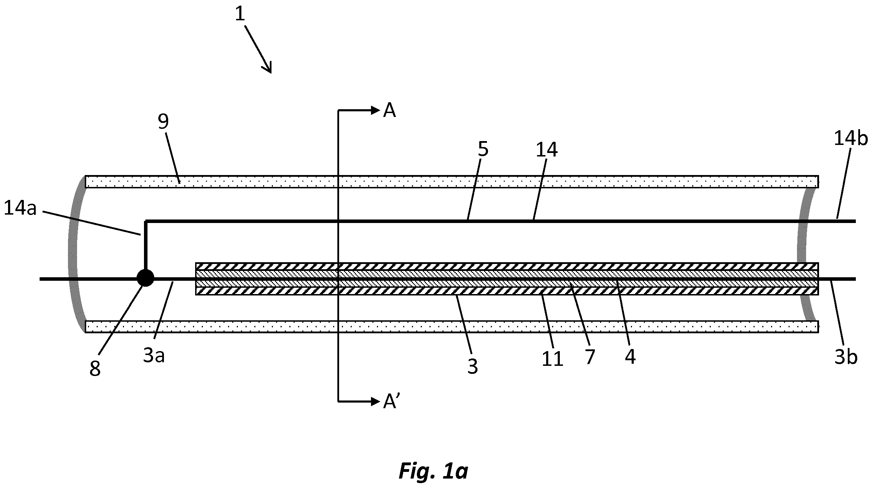

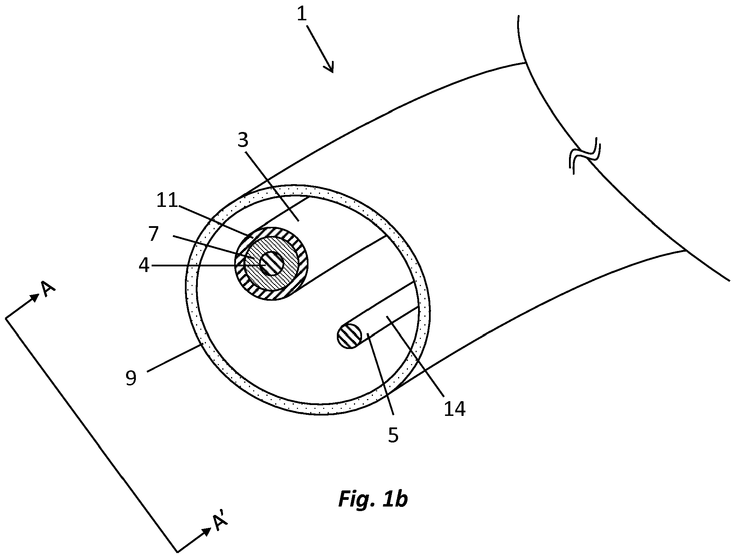

Figure 1a shows a longitudinal section view of an exemplary cable assembly 1; Figure 1b shows a cross sectional view of the cable assembly 1 taken along line A-A' of Figure 1a. Referring to Figures 1a and 1b, it can be seen that the cable assembly 1 comprises a main lead 3 and an auxiliary lead 5 which are electrically connected to one another.

The main lead 3 comprises a first end portion 3a and a second, opposite end portion 3b; the first end portion can be connected to an external electrical connection; the second end portion 3b can be selectively electrically connected to a measurement circuit (not shown).

The main lead 3 comprises a first electrically conductive wire 4 having a first electrically conductive sheath 7 which has a first predefined resistance (i.e. a first predefined electrical resistance). In an embodiment the first electrically conducting sheath 7 comprises a matrix, and a plurality of electrically conductive elements at least some of which are both partially embedded in the matrix and are in mechanical and electrical contact with said first electrically conductive wire 4, and wherein said plurality of electrically conductive elements are electrically connected to one another within the matrix. The material, shape and density of the electrically conductive elements which are embedded in the matrix will dictate the first predefined resistance. However it should be understood that the first electrically conductive sheath 7 is not limited to requiring a matrix with a plurality of electrically conductive elements at least some of which are both partially embedded in the matrix and are in mechanical and electrical contact with said first electrically conductive wire 4, on the contrary the first electrically conductive sheath 7 may take any suitable configuration. For example, the first electrically conductive sheath 7 may comprise conductive polymers such as poly(3,4-ethylenedioxythiophene) (PEDOT), polyaniline (PANI), polythiophene, polypyrrole.

The main lead 3 further comprises an insulating sheath 11 which covers the first electrically conductive sheath 7, however it should be understood that the insulating sheath 11 is an optional feature.

Most preferably the main lead 3 is configured to be flexible. This can be achieved by forming each of the electrically conductive wire 4, first electrically conductive sheath 7, and the insulating sheath 11 (if present), from flexible material. For example the first electrically conductive wire 4 may comprise any of copper, aluminium, silver, gold, platinum, and/or alloys (nickel-chrome, bronze, phosphor bronze, brass); the electrically conductive sheath 7, may comprise any of a flexible matrix, and a plurality of electrically conductive elements at least some of which are both partially embedded in the matrix and are in mechanical and electrical contact with said wire, and wherein said plurality of electrically conductive elements are electrically connected to one another within the matrix; the electrically conductive sheath 7, may comprise conductive polymers such as poly(3,4-ethylenedioxythiophene) (PEDOT), polyaniline (PANI), polythiophene, polypyrrole; the insulating sheath 11 may comprise any one or more of polyethylene, cross-linked polyethylene, polyvinyl chloride, polypropylene, ethylene propylene, polyolefin, silicone rubber, fluorine plastic, nylon, or any other suitable insulating material.

The auxiliary lead 5 comprises at least a second electrically conductive wire 14, having a first end portion 14a and a second, opposite end portion 14b, the first end portion 14a being connected to the first end portion 3a of the first electrically conductive wire 4 at a first node 8; this results in the main lead 3 and auxiliary lead 5 being electrically connected in series.

The second end portion 14b of the second electrically conductive wire can be selectively electrically connected to a measurement circuit (not shown).

Most preferably the auxiliary lead 5 is configured to be flexible. This can be achieved by forming each of the second electrically conductive wire 14 from flexible material. For example the electrically conductive wire 4 may comprise any of copper, aluminium, silver, gold, platinum, and/or alloys (nickel-chrome, bronze, phosphor bronze, brass).

The main lead 3 and the auxiliary lead 5 are arranged to be side-by-side along the majority of the length of the main lead and auxiliary lead. In this particular embodiment the main lead 3 and the auxiliary lead 5 are arranged to be substantially parallel along the majority of the length of the main lead 3 and the auxiliary lead 5; however it should be understood that it is not essential for the main lead 3 and the auxiliary lead 5 be precisely parallel to one another.

The cable assembly 1 further comprises an insulating jacket 9; however it should be understood that the insulating jacket 9 is an optional feature. In this embodiment the main lead 3 and auxiliary lead 5 share a common insulating jacket 9; in other words a single insulating jacket 9 is provided and both the main lead 3 and auxiliary lead 5 are housed within the single insulating jacket 9. However, it is not essential that the main lead 3 and auxiliary lead 5 share a common insulating jacket 9; in another embodiment the main lead 5 comprises a first insulating jacket, and the auxiliary lead comprises a second insulating jacket; in other words each of the main lead 3 and auxiliary lead 5 are provided with a respective insulating jacket.

Preferably the insulating jacket 9 is configured to be flexible. This can be achieved by forming the insulating jacket 9 from flexible material. For example the insulating jacket 9 may comprise any one or more of polyethylene, cross-linked polyethylene, polyvinyl chloride, polypropylene, ethylene propylene, silicone rubber polyolefin, fluorine plastic, nylon, or any other suitable insulating material.

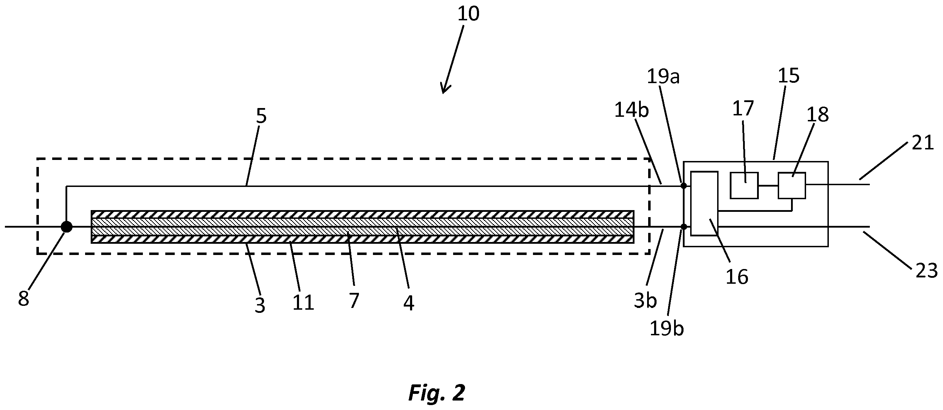

Figure 2 shows a longitudinal section view of an exemplary cable assembly 10; The cable assembly 10 has many of the same features as the cable assembly 1 shown in Figures 1a and 1b and like features are awarded the same reference numbers.

The cable assembly 10 comprises a measurement circuit 15 which may be configured such that it can determine the resistance (R_{measured}) of the main lead 3 and auxiliary lead 5; compare the determined resistance (R_{measured}) to at least a first predefined threshold resistance value (R1_{threshold}). If the determined resistance (R_{measured}) is greater than the first predefined threshold resistance value (R1_{threshold}) then this will indicate that a break has occurred in the first electrically conductive wire 4 of the main lead 3. Most preferably the measurement circuit 15 is configured to issue an alarm if the determined resistance (R_{measured}) is greater than the first predefined threshold resistance value (R1_{threshold}).

In an embodiment, the measurement circuit 15 may be configured such that it can determine the resistance (R_{measured}) of the main lead 3 only; compare the determined resistance (R_{measured}) to at least a first predefined threshold resistance value (R1_{threshold}). If the determined resistance (R_{measured}) is greater than the first predefined threshold resistance value (R1_{threshold}) then this will indicate that a break has occurred in the first electrically conductive wire 4 of the main lead 3. Most preferably the measurement circuit 15 is configured to issue an alarm if the determined resistance (R_{measured}) is greater than the first predefined threshold resistance value (R1_{threshold}).

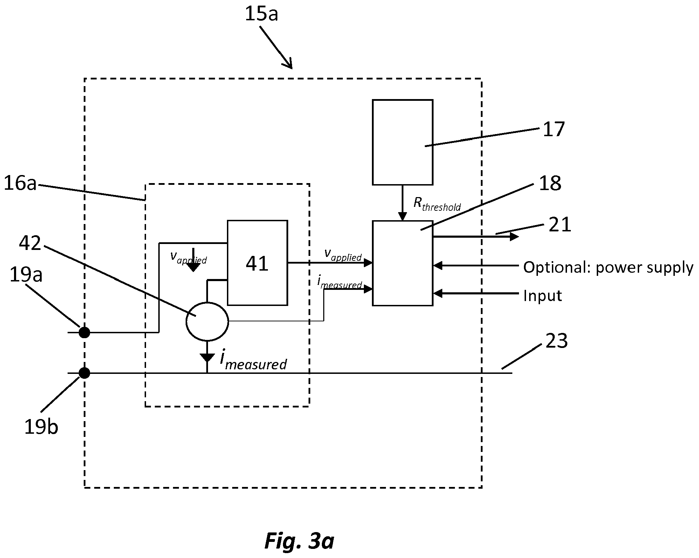

It will be understood that the measurement circuit 15 in the cable assembly 10 may take any suitable configuration which enables the measurement circuit 15 to determine the resistance (R_{measured}) of the main lead 3 and auxiliary lead 5 or to determine the resistance (R_{measured}) of the main lead. As will be described in more detail below with respect to Figures 3a-e, there are many different possible implementations for the measurement circuit 15 of the cable assembly 10. In cable assembly 10 the measurement circuit comprises an electronic testing module 16, a memory 17 and a processor 18.

The second end portion 3b of the first electrically conductive wire 4 is connected to the measurement circuit 15 at a second node 19 and the second end portion 14b of the second electrically conductive wire 14 is connected to the measurement circuit 15 at a third node 19b. The electronic testing module 16 is electrically connected to the respective second and third nodes 19a,19b.

The electronic testing module 16 may be configured so that it can provide the processor 18 with electrical parameters necessary for the processor to calculate the resistance (R_{measured}) of the main lead 3 and auxiliary lead 5 between the second and third nodes 19a,19b. As will be described in more detail below, the electronic testing module 16 may comprise a current measuring means configured to, or configurable to, measure the current (I_{measured}) which flows into the third node 19b; the electronic testing module 16 may comprise a current source which is configured to deliver a test current (I_{applied}) to the third node 19b (and thus to the main lead and auxiliary lead); the electronic testing module 16 may comprise a voltage measuring means configured to measure the voltage (V_{measured}) across the second and third nodes 19a,19b (i.e. the voltage across the auxiliary lead 5 and the main lead 3, between the second and third nodes 19a,19b); the electronic testing module 16 may comprise a voltage source configured to apply a test voltage (V_{applied}) across the main lead and auxiliary lead i.e. apply a test voltage across the second and third nodes 19a,19b.

The electronic testing module 16 may be configured such that it can provide the processor 18 with said current measurement (I_{measured}) taken by the current measuring means and/or the level of test current (I_{applied}) which the current source delivered, and/or said measured voltage (V_{measured}) taken by the voltage measuring means, and/or the level of test voltage (V_{applied}) which the voltage source applied.

The processor 18 may be configured to use the measured voltage (V_{measured}) or level of test voltage (V_{applied}), and current measurement (I_{measured}) or said level of test current (I_{applied}), to calculate the resistance (R_{measured}) of the main lead 3 and auxiliary lead 5, between the second and third nodes 19a,19b (according to the formula V_{measured} / I_{measured} = R_{measured} or V_{applied} / I_{measured} = R_{measured} or V_{measured} / I_{applied} = R_{measured}). The processor 18 is operably connected to the electronic testing module 16 so that the processor 18 can receive said current and voltage values from the electronic testing module 16.

In another embodiment, the processor 18 may be configured to use the measured voltage (V_{measured}), and current measurement (I_{measured}), to calculate the resistance (R_{measured}) of the main lead 3, between the first and third nodes 8,19b (according to the formula V_{measured} / I_{measured} = R_{measured}). The processor 18 is operably connected to the electronic testing module 16 so that the processor 18 can receive said current and voltage values from the electronic testing module 16.

The memory 17 of the measurement circuit 15 stores at least a first predefined threshold resistance value (R1_{threshold}). The processor 18 is also operably connected to the memory 17 so that the processor 18 can receive said stored at least a first predefined threshold resistance value (R1_{threshold}) from the memory 17.

The processor is further configured to receive said stored first predefined threshold resistance value (R1_{threshold}) from the memory 17 and to compare said calculated resistance (R_{measured}) with the first predefined threshold resistance value (R1_{threshold}). If the calculated resistance (R_{measured}) is greater than the first predefined threshold resistance value (R1_{threshold}), this indicates that a break has occurred in either the first electrically conductive wire 4 of the main lead 3 or that a break has occurred in the second electrically conductive wire 14 of the auxiliary lead 5.

The processor 18 is configured to issue an alarm if the calculated resistance (R_{measured}) is greater than the first predefined threshold resistance value (R1_{threshold}). The alarm may take any suitable form for example the alarm may be a visible alarm signal, e.g. LED, an audible alarm signal, e.g. buzzer, and/or a digital status signal providing information about the health status of the cable assembly, e.g. "main lead broken, replacement is required". Optionally the processor 18 may be further configured to issue an assurance signal e.g. "cable fully intact", if the calculated resistance (R_{measured}) is less than the first predefined threshold resistance value (R1_{threshold}). In this example the measurement circuit 15 further comprises an output 21 (the processor 18 is connected to the output; if the processor is to issue an alarm signal it can provide a signal to the output 21 which will generate the alarm); most preferably the measurement circuit 15 will issue an alarm signal at the output 21 if the calculated resistance (R_{measured}) is greater than the first predefined threshold resistance value (R1_{threshold}).

The measurement circuit 15 further comprises a main lead contact 23. The main lead contact 23 is connected (or can be selectively connected) to the first electrically conductive wire 4 of the main lead. The main lead contact 23 can output signals which have been transmitted along the main lead 3; most preferably the main lead contact 23 outputs signals which have been transmitted along the main lead 3 from the first end portion 3a of the main lead 3, to the second end portion 3b of the main lead 3, or the main lead contact 23 acts as an input for signals which are to be transmitted along the main lead 3 from the second end portion 3b of the main lead 3, to the first end portion 3a of the main lead 3. Typically, the main lead contact 23 will be further electrically connected to external circuitry, thus signal(s) transmitted along the main lead 23 from the first end portion 3a of the main lead 3, to the second end portion 3b of the main lead 3 can be sent to the external circuitry via the main lead contact 23, or signal(s) received from the external circuitry can be transmitted along the main lead 23 from the second end portion 3b of the main lead 3, to the first end portion 3a of the main lead 3.

The memory 17 of the measurement circuit 15 stores a second predefined threshold resistance value (R2_{threshold}). The processor 18 is also operably connected to the memory 17 so that the processor 18 can receive said stored second predefined threshold resistance value (R2_{threshold}) from the memory 17 (the second predefined threshold resistance value (R2_{threshold}) being larger than the first predefined threshold resistance value (R1_{threshold}). The processor 18 is further configured to compare said calculated resistance (R_{measured}) with the second predefined threshold resistance value (R2_{threshold}) if the calculated resistance (R_{measured}) is greater than the first predefined threshold resistance value (R1_{threshold}). If said calculated resistance (R_{measured}) is greater than both the first predefined threshold resistance value (R1_{threshold}) and the second predefined threshold resistance value (R2_{threshold}) this indicates that there is an unacceptable number of breaks in the electrically conductive wire 4 or that there is an unacceptable extent of damage to the first electrically conductive wire 4 and the first electrically conductive sheath 7 of the main lead 3; if said calculated resistance (R_{measured}) is greater than the first predefined threshold resistance value (R1_{threshold}) but is less than the second predefined threshold resistance value (R2_{threshold}) this indicates that there is one or more breaks in the electrically conductive wire 4 (and also possibly some damage to the first electrically conductive sheath 7) of the main lead 3 but that the number of breaks (and extent of damage) is acceptable. Preferably the processor 18 is configured to issue a first alarm if the calculated resistance (R_{measured}) is greater than the first predefined threshold resistance value (R1_{threshold}) and the calculated resistance (R_{measured}) is less than the second predefined threshold resistance value (R2_{threshold}); and is configured to issue a second alarm (which is preferably different to the first alarm) if the calculated resistance (R_{measured}) is greater than the first predefined threshold resistance value (R1_{threshold}) and the calculated resistance (R_{measured}) is greater than the second predefined threshold resistance value (R2_{threshold}).

The processor 18 is configured to update the first predefined threshold resistance value (R1_{threshold}) stored in the memory 17, if the calculated resistance (R_{measured}) is greater than the first predefined threshold resistance value (R1_{threshold}) and the calculated resistance (R_{measured}) is less than the second predefined threshold resistance value (R2_{threshold}). The processor 18 may be configured to update the first predefined threshold resistance value (R1_{threshold}) to be equal to the "calculated resistance (R_{measured}) + a predefined first resistance increase value (R_{inc1})" wherein said predefined first resistance increase value (R_{inc1}) is the resistance increase of the main lead 3 which is expected when a break occurs in the first electrically conductive wire 4 of the main lead. The measured resistance is proportional to the number of breaks in the first electrically conductive wire 4 and/or the extent of damage to the first electrically conductive sheath 7 of the main lead 3 and/or the extent of damage to the second electrically conductive wire 14; the predefined maximum resistance R2threshold is the maximum tolerable resistance increase (which in turn reflects how many breaks and how much damage to the main lead is to be tolerated), and it can be chosen depending on the application in which the cable assembly is used.

It should be noted that the predefined first resistance increase value (R_{inc1}) could be determined in a calibration process using a test lead which is similar to the main lead 3, which involves measuring a first resistance of the test lead (unbroken), then providing a break in the conductive wire of the test lead and measuring a second resistance of the test lead; then subtracting the measured first resistance from the measured second resistance to determine the increase in the predefined first resistance increase value (R_{inc1}).

As mentioned there are many different possible implementations for the measurement circuit 15 of the cable assembly 10. Figures 3a-e illustrate different possible configurations for the measurement circuit 15 of the cable assembly 10; it will be understood that any of these different possible configurations could be used in the cable assembly 10. It should be understood that any of the different possible configurations for the measurement circuit 15 shown in Figures 3a-e can be used in the measurement circuit 15 of any of the cable assemblies described in this application.

Figure 3a illustrates one possible implementation for the measurement circuit 15. In this example the measurement circuit 15a comprises an electronic testing module 16a which comprises a voltage module 41 which is electrically connected to the second node 19a and also electrically connected to the third node 19b. The voltage module 41 comprises a voltage source which can selectively provide a test voltage (V_{applied}) across the main lead 3 and auxiliary lead 5 which are connected in series i.e. apply a test voltage (V_{applied}) across the second and third nodes 19a,19b, where the connection to the third node 19b passes through the current measurement means 42.

The electronic testing module 16a further comprises a current measurement means 42 which is connected to the third node 19b, so that the current measurement means 42 can measure current (I_{measured}) which flows into the third node 19b (i.e. the current measurement means 42 measures current which flows through the first electrically conductive wire 4 of the main lead 3) after the voltage module 41 has applied the test voltage (V_{applied}).

Preferably the processor 18 is configured to control the voltage module 41 and the current measurement means 42; the processor 18 may be configured to initiate the voltage module 41 to provide a test voltage (V_{applied}) and initiate the current measurement means 42 to measure current (I_{measured}).

The processor 18 is configured to receive from the voltage module 41 the level of the test voltage (V_{applied}) which the voltage module 41 applied, and to receive from the current measurement means 42 said current measurement (I_{measured}) taken by the current measurement means 42 after the voltage module 41 has applied the test voltage (V_{applied}). Optionally, the processor may be configured to initiate the voltage module 41 to stop applying the test voltage, and to initiate the current measurement means 42 to stop measuring current, after the processor has received said level of the test voltage (V_{applied}) and said current measurement (I_{measured}).

The processor 18 is configured to calculate a resistance (R_{measured}) of the main lead 3 and auxiliary lead 5, between the second and third nodes 19a,19b, using said level of the test voltage (V_{applied}) and current measurement (I_{measured}), according to the formula V_{applied} / I_{measured} = R_{measured}.

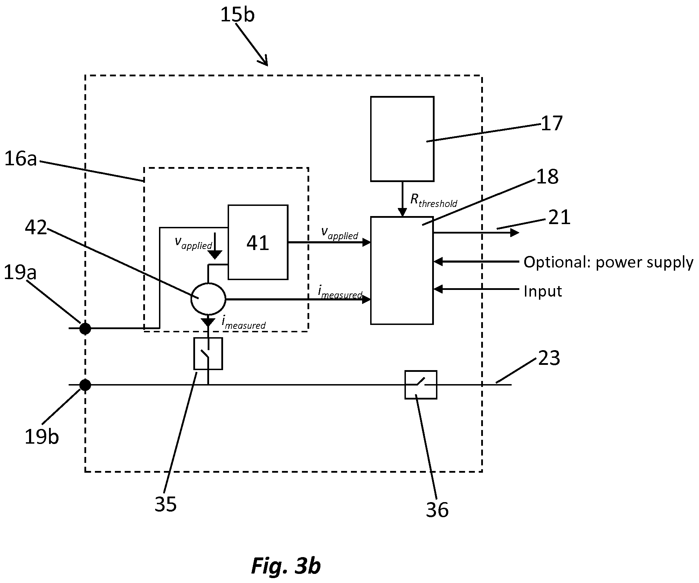

Figure 3b illustrates another possible implementation for the measurement circuit 15. The measurement circuit 15b has many of the same features as the measurement circuit 15a shown in Figure 3a and like features are awarded the same reference numbers.

The measurement circuit 15b illustrated in Figure 3b further comprises a first switch 35 which is connected in series with the electronic testing module 16a. The first switch 35 is located between the third node 19b and the electronic testing module 16a.

The measurement circuit 15b further comprises a second switch 36 which is between the third node 19b and the main lead contact 23.

Most preferably the processor 18 is further configured to control the opening and closing of the first and second switches 35,36. More specifically, the processor is preferably configured to close the first switch 35 and open the second switch 36, prior to initiating the voltage source to provide said test voltage (V_{applied}) across the main lead 3 and auxiliary lead 5 (and prior to initiating the current measurement means 42 to measure current (I_{measured})).

Closing the first switch 35 allows current (e.g. current which has resulted from the application of the test voltage (V_{applied}) to the auxiliary lead 5 by the voltage source of the voltage module 41) arriving at the third node 19b to pass to the current measurement means 42 of the electronic testing module 16a. Opening the second switch 36 ensures that any current signals conducted along the main lead 5 during the test, do not pass to the main lead contact 23 (and thus do not pass to external circuitry which may be connected to the main lead contact 23).

Optionally, after the processor 18 has received said level of the test voltage (V_{applied}) and said current measurement (I_{measured}), from the respective voltage module 41 and current measurement means 42, the processor may open the first switch 35 and close the second switch 36.

When the first switch 35 is open current conducted along the main lead 3 to the third node 19b is prevented from passing to the electronic testing module 16a. When the second switch 36 is closed the current arriving at the third node 19b can be conducted, via the closed second switch 36, to the main lead contact 23. Thus when the first switch 35 is opened and the second switch 36 is closed, current conducted along the main lead 3 to the third node 19b can pass directly from the third node 19b to the main lead contact 23, and thus to any external circuitry which is connected to the main lead contact 23.

It should be understood that the switches 35,36 may be combined in a single toggle switch which may, in a first toggle state, connect the third node 19b to either the electronic testing module 16a and which may, in a second toggle state, connect the third node 19b to the main lead contact 23.

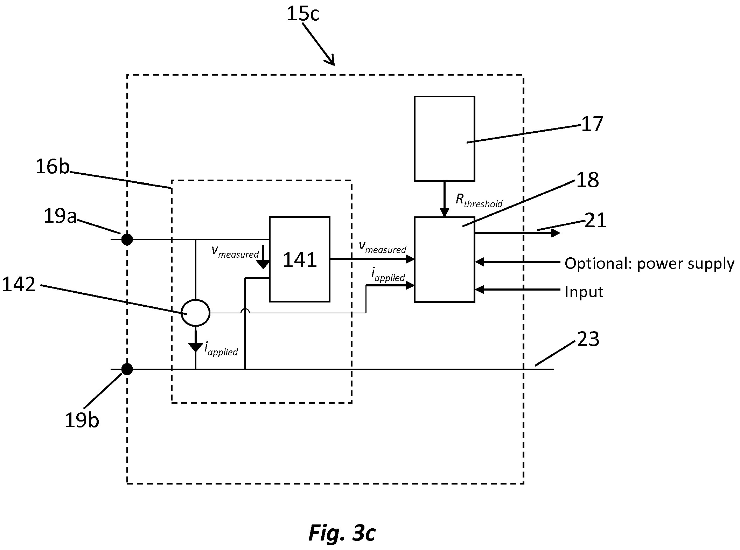

Figure 3c illustrates another possible implementation for the measurement circuit 15. In this example the measurement circuit 15c comprises an electronic testing module 16b which comprises a voltage module 141 which is electrically connected to the second node 19a and also electrically connected to the third node 19b. The voltage module 141 comprises a voltage measurement means which can selectively measure the voltage (V_{measured}) across the main lead 3 and auxiliary lead 5 which are connected in series i.e. measure the voltage (V_{measured}) across the second and third nodes 19a,19b.

The electronic testing module 16b further comprises a current source 142 which is connected to the third node 19b, so that the current source 142 can apply a test current (I_{applied}) to the third node 19b; the applied test current (I_{applied}) will flow into the third node 19b, along the main lead 3 and auxiliary lead 5 and into the second node 19a. The voltage module 141 is configured to measure the voltage (V_{measured}) across the main lead 3 and auxiliary lead 5 which are connected in series (i.e. measure the voltage (V_{measured}) across the second and third nodes 19a,19b) after the current source 142 has applied a test current (I_{applied}) to the third node 19b.

Preferably the processor 18 is configured to control the voltage module 141 and the current source 142; the processor 18 may be configured to initiate the current source 142 to apply a test current (I_{applied}) to the third node 19b, and to initiate the voltage module 41 to measure the voltage (V_{measured}) (resulting from the test current (I_{applied})) across the main lead 3 and auxiliary lead 5.

The processor 18 is configured to receive from the current source 142 said level of current which the current source 142 applied as the test current (I_{applied}), and to receive from the voltage module 141 said voltage measurement (V_{measured}) taken by the voltage measurement means of the voltage module 141 after the current source 142 applied the test current (I_{applied}). Optionally, the processor 18 may be configured to initiate the current source 142 to stop apply a test current (I_{applied}) to the third node 19b and to initiate the voltage module 41 to stop measuring voltage, after the processor has received said level of the test current (I_{applied}) and said voltage measurement (V_{measured}).

The processor 18 is configured to calculate a resistance (R_{measured}) of the main lead 3 and auxiliary lead 5, between the second and third nodes 19a,19b, using said voltage measurement (V_{measured}) and said level of test current (I_{applied}), according to the formula V_{measured}/ I_{applied} = R_{measured}.

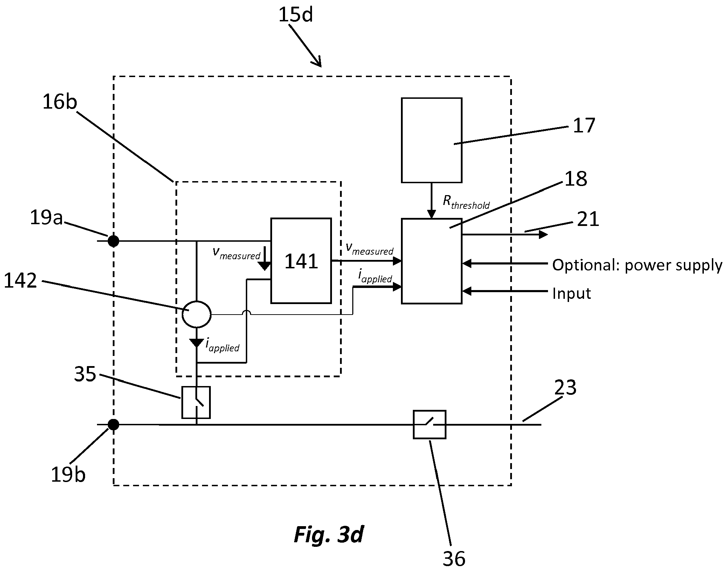

Figure 3d illustrates another possible implementation for the measurement circuit 15. The measurement circuit 15d has many of the same features as the measurement circuit 15a shown in Figure 3a and like features are awarded the same reference numbers.

The measurement circuit 15d illustrated in Figure 3d further comprises a first switch 35 which is connected in series with the electronic testing module 16b. The first switch 35 is located between the third node 19b and the electronic testing module 16b.

The measurement circuit 15d further comprises a second switch 36 which is between the third node 19b and the main lead contact 23.

Most preferably the processor 18 is further configured to control the opening and closing of the first and second switches 35,36. More specifically, the processor is preferably configured to close the first switch 35 and open the second switch 36, prior to initiating the current source to apply said test current (I_{applied}) (and prior to initiating the voltage module 141 to measure the voltage (Vmeasured)).

Closing the first switch 35 allows the test current (I_{applied}) to flow from the current source to the third node 19b, and thus into the main lead (and subsequently into the auxiliary lead to the second node 19a). Opening the second switch 36 ensures that the test current (I_{applied}) does not pass to the main lead contact 23 (and thus does not pass to external circuitry which may be connected to the main lead contact 23).

Optionally, after the processor 18 has received said level of the test current (I_{applied}) from the current source 142 and said voltage measurement (V_{measured}) from the voltage module 141, the processor 18 may open the first switch 35 and close the second switch 36.

When the first switch 35 is open, current conducted along the main lead 3 to the third node 19b is prevented from passing to the electronic testing module 16a. When the second switch 36 is closed the current arriving at the third node 19b can be conducted, via the closed second switch 36, to the main lead contact 23. Thus when the first switch 35 is opened and the second switch 36 is closed, current conducted along the main lead 3 to the third node 19b can pass directly from the third node 19b to the main lead contact 23, and thus to any external circuitry which is connected to the main lead contact 23.

It should be understood that the switches 35,36 may be combined in a single toggle switch which may, in a first toggle state, connect the third node 19b to the electronic testing module 16b and which may, in a second toggle state, connect the third node 19b to the main lead contact 23.

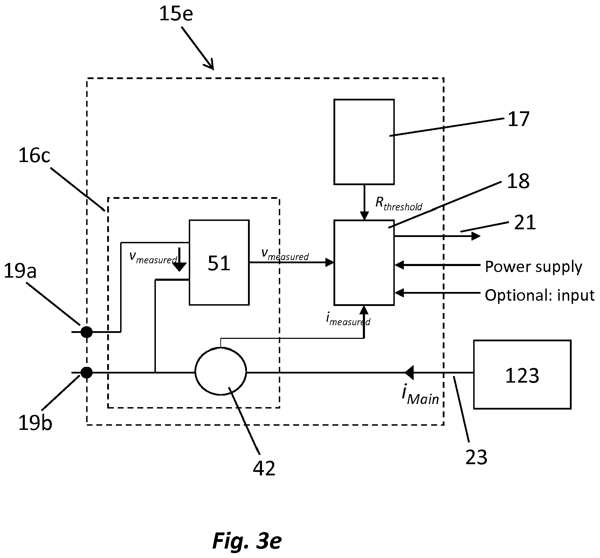

Figure 3e illustrates another possible implementation for the measurement circuit 15. In this example the measurement circuit 15e comprises an electronic testing module 16c which comprises a voltage module 51 which is electrically connected to the second node 19a and also electrically connected to the third node 19b. The voltage module 51 comprises a voltage measurement means which is configured to measure the voltage (V_{measured}) between the second and third nodes 19a,19b.

A voltage between the second and third nodes 19a,19b can be achieved by a current which is supplied to the first end portion 3a of the main lead 3 (e.g. the current may be supplied by an external circuit or external power source which is electrically connected to the first end portion 3a of the main lead 3). In this example preferably the main lead contact 23 is electrically connected to an external circuit 123.

The electronic testing module 16c further comprises a current measurement means 42 which is connected to the third node 19b, so that the current measurement means 42 can measure current (I_{measured}) which flows through the main lead 3.

Preferably the processor 18 is configured to control the voltage module 51 and the current measurement means 42; the processor 18 may be configured to initiate the voltage module 51 to measure the voltage (V_{measured}) between the second and third nodes 19a,19b, and to initiate the current measurement means 42 to measure current (I_{measured}), after a current is supplied to the first end portion 3a of the main lead 3.

The processor 18 is configured receive from the voltage module 51 the measurement of the voltage (V_{measured}) between the second and third nodes 19a,19b taken by the voltage module 51, and to receive from the current measurement (I_{measured}) taken by the current measurement means 42. The processor 18 is configured to calculate a resistance (R_{measured}) of the main lead 3 between first node 8 and the third node 19b, using the measured voltage (V_{measured}) and the measured current (I_{measured}), according to the formula V_{measured} / I_{measured} = R_{measured}.

The processor 18 may be configured to initiate the voltage module 51 to stop measuring the voltage (V_{measured}) between the second and third nodes 19a,19b, after the processor 18 has received the measurement of the voltage (V_{measured}). The processor 18 may be configured to initiate the current measurement means 42 to stop measuring current, after the processor 18 has received the current measurement (I_{measured}) from the current measurement means 42.

In the measurement circuit 15e shown in Figure 3e, the processor 18 may be configured to calculate the resistance (R_{measured}) of the main lead 3 and auxiliary lead 5, only if the measured current (I_{measured}) is not 'zero'. In other words the processor 18 is configured to first check if the current measurement (I_{measured}) taken by the current measurement means 42 is 'a non-zero value'; and only if the current measurement (I_{measured}) is a non-zero value does the processor then calculate said resistance (R_{measured}) of the main lead 3 and auxiliary lead 5, between the second and third nodes 19a,19b. Most preferably the processor is configured to issue a first alarm if the current measurement (I_{measured}) taken by the current measurement means 42 is 'zero'. If current is expected to be supplied to the first end portion 3a of the main lead 3, but the current measurement (I_{measured}) is 'zero', this indicates that there is a break both in the first electrically conductive wire 4 and the first conductive sheath 7 of the main lead 3, and that the break in the first conductive sheath 7 is such that the first conductive sheath 7 does not provide an electrical connection between the individual pieces of wire resulting from the break in the first electrically conductive wire 4. If the current measurement (I_{measured}) is 'non-zero' then the processor 18 calculates the resistance (R_{measured}) as described above and compares the calculated resistance (R_{measured}) with the first predefined threshold resistance value (R1_{threshold}). The processor 18 issues a second alarm (which is preferably different to the first alarm), if the calculated resistance (R_{measured}) is larger than the first predefined threshold resistance value (R1_{threshold}).

Optionally, in a further embodiment, the processor may be further configured to further determine if the voltage measured by the voltage module 51 is a floating voltage. The processor may be configured to calculate the resistance (R_{measured}) of the main lead 3 and auxiliary lead 5, only if the measured current (I_{measured}) is not 'zero' and the voltage measured (V_{measured}) by the voltage module 51 is not a floating voltage. This solves the problem that the voltage module 51 cannot correctly determine the voltage across the main lead 3 if there is a complete interruption in the auxiliary lead 5.

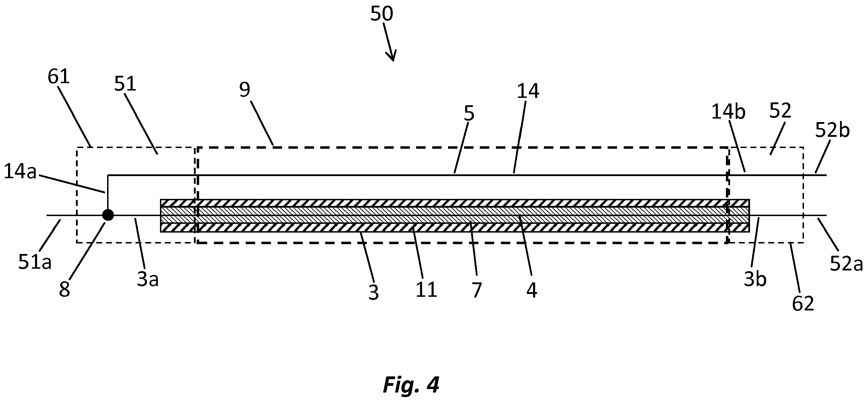

Figure 4 shows a longitudinal section view of a cable assembly 50 according to an aspect of the present invention. The cable assembly 50 has many of the same features as the cable assembly 1 according to Figure 1 and like features are awarded the same reference numbers.

The cable assembly 50 further comprisesa first plug member 51 and a second plug member 52. The first electrically conductive wire 4 extends between first plug member 51 and the second plug member 52, the first end portion 3a of said first electrically conductive wire 4 is connected to a first electrical contact 51a of the first plug member 51 and a second, opposite, end portion 3b of said first electrically conductive wire 4 is connected to a first electrical contact 52a of the second plug member 52, so that said first electrically conductive wire 4 electrically connects the first and second plug members 51,52. Most preferably the first and second plug members 51,52 each comprise a rigid housing 61,62.

The first node 8 is housed within the first plug member 51. Preferably first node 8 is housed within rigid housing 61 of the first plug member 51. The second electrically conductive wire 14 extends from the first node 8 to the second plug member 52.

In the cable assembly 50 the second opposite end portion 14b of the second electrically conductive wire 14 is connected to a second electrical contact 52b of the second plug member 52.

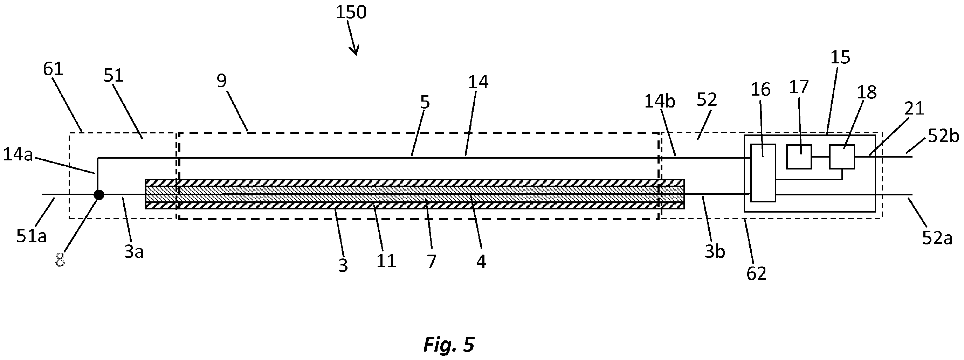

Figure 5 shows a longitudinal section view of a cable assembly 150 according to an aspect of the present invention. The cable assembly 150 has many of the same features as the cable assembly 50 shown in Figure 4 and like features are awarded the same reference numbers.

The cable assembly 150 further comprises a measurement circuit 15, which has the same features, and operates in the same manner, as the measurement circuit 15 of the cable assembly 10 of Figure 2 (it follows that the measurement circuit 15 can have any of the configurations shown in Figures 3a-e).

In the cable assembly 150 the measurement circuit 15 is housed in the second plug member 52. Specifically the measurement circuit 15 is housed within rigid housing 62 of the second plug member 52. Accordingly, the second end portion 3b of the first electrically conductive wire 4 is electrically connected to the measurement circuit 15 within the housing of the second plug member 52; likewise the second end portion 14b of the second electrically conductive wire 14 is electrically connected to the measurement circuit 15 within the housing of the second plug member 52.

In the cable assembly 150, the main lead contact 23 of the measurement circuit 15 is electrically connected to the first electrical contact 52a of the second plug member 52. The output 21 of the measurement circuit 15 is electrically connected to the second electrical contact 52b of the second plug member 52.

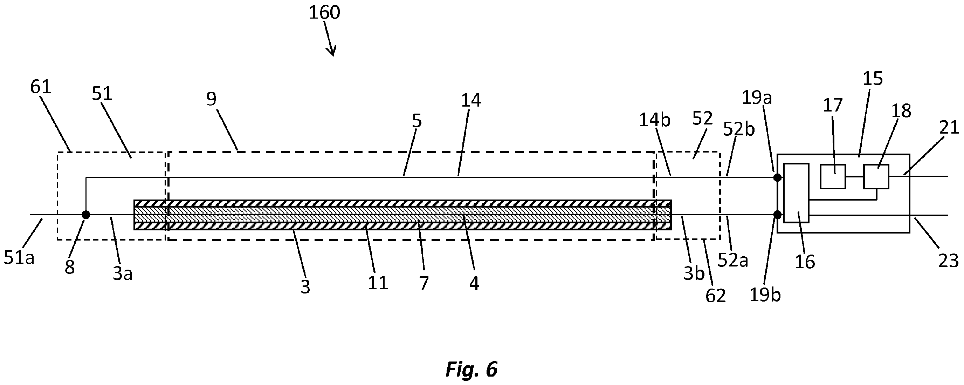

Figure 6 shows a longitudinal section view of a cable assembly 160 according to an aspect of the present invention.

The cable assembly 160 has many of the same features as the cable assembly 50 shown in Figure 4 and like features are awarded the same reference numbers.

The cable assembly 160 further comprises a measurement circuit 15, which has the same features, and operates in the same manner, as the measurement circuit 15 of the cable assembly 10 of Figure 2 (it follows that the measurement circuit 15 can have any of the configurations shown in Figures 3a-e).

Unlike the cable assembly 150 shown in Figure 5 in the cable assembly 160 the measurement circuit 15 is external to the second plug member 52. The second plug member 52 can be arranged to be electrically connected to the measurement circuit 15. For example, the second plug member 52 can be selectively arranged to be plugged into the measurement circuit 15, or unplugged from the measurement circuit 15. In another embodiment the second plug member 52 is fixedly connected to the measurement circuit 15 e.g. by means of a solder connection.

Figure 6 shows the second plug member 52 arranged to be electrically connected to the measurement circuit 15 (in this embodiment the second plug member 52 is arranged to be plugged into the measurement circuit 15). When the second plug member 52 is arranged to be electrically connected to the measurement circuit 15, the first electrical contact 52a of the second plug member 52 electrically connects to the measurement circuit 15 thereby electrically connecting the second end portion 3b of the first electrically conductive wire 4 to the measurement circuit 15 (specifically the first electrical contact 52a of the second plug member 52 electrically connects to the third node 19b); and also the second electrical contact 52b of the second plug member 52 electrically connects to the measurement circuit 15 (specifically the second electrical contact 52b of the second plug member 52 electrically connects to the second node 19a) thereby electrically connecting the second end portion 14b of the second electrically conductive wire 14 to the measurement circuit 15.

It should be understood that in a variation of any of the cable assemblies 1,10,50,150,160, embodiments described above, the second electrically conductive wire 14 of the auxiliary lead 5 of that cable assembly 1,10,50,150,160 may further comprise a second electrically conductive sheath. According to an aspect of the invention the second electrically conductive sheath has a second predefined resistance which is different to the first predefined resistance of the first electrically conductive sheath 7 provided on the first electrically conductive wire 4 of the main lead 3.

The second electrically conducting sheath may comprise a matrix, and a plurality of electrically conductive elements at least some of which are both partially embedded the matrix and are in mechanical and electrical contact with said second electrically conductive wire 14, and wherein said plurality of electrically conductive elements are electrically connected to one another within the matrix. An electrically conductive element may be electrically connected to another electrically conductive element by said two electrically conductive elements arranged to physically touch each other within the matrix; for example the portion of one of the electrically conductive element which is embedded in the matrix may physically contact the portion of the other electrically conductive element which is embedded within the matrix so that the two electrically conductive elements physically touch each other within the matrix. Alternatively, or additionally, an electrically conductive element may be electrically connected to another electrically conductive element via one or more other electrically conductive element(s) each of the one or more other electrically conductive element(s) being in electrical connection with said two electrically conductive elements. For example a first electrically conductive element may be in physical contact, within the matrix, with a second electrically conductive element, the second electrically conductive element may be in physical contact, within the matrix, with a third electrically conductive element, the third electrically conductive element may be in physical contact, within the matrix, with a fourth electrically conductive element, so that the first and fourth electrically conductive element are electrically connected via the second and third electrically conductive elements. In this case, one possible way to achieve the first predefined resistance being substantially equal to (or equal to) the second predefined resistance, is by ensuring that the density of the electrically conductive elements in the matrix of the first electrically conductive sheath substantially equal to (or equal to) the density of the electrically conductive elements in the matrix of the second electrically conductive sheath. One possible way to achieve the first predefined resistance being different to the second predefined resistance, is by ensuring that the density of the electrically conductive elements in the matrix of the first electrically conductive sheath is different to the density of the electrically conductive elements in the matrix of the second electrically conductive sheath.

Furthermore the auxiliary lead 5 may further comprise a second insulating sheath which covers the second electrically conductive sheath. However it should be understood that the second insulating sheath is an optional feature.

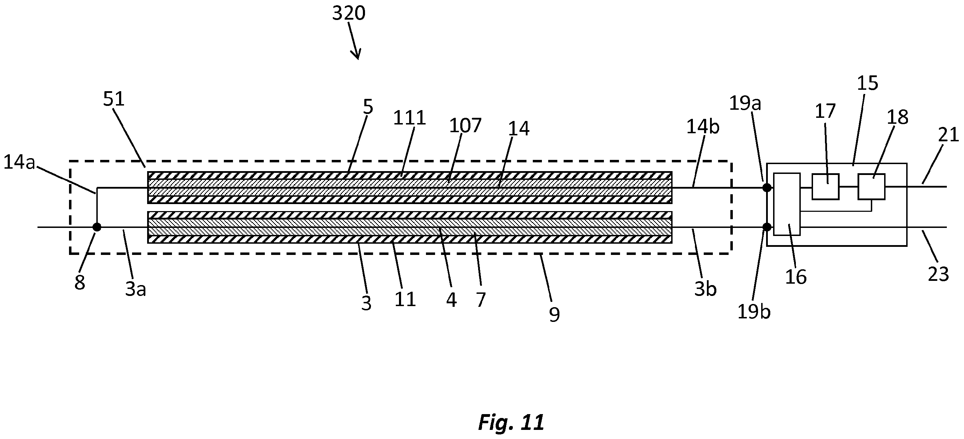

Figure 11 shows a longitudinal section view of a cable assembly 320 according to a further embodiment of the present invention. The cable assembly 320 comprises many of the same features as the cable assembly 10 of Figure 2 and like features are awarded the same reference numbers.

In the cable assembly 320 the auxiliary lead 5 further comprises a second electrically conductive sheath 107 which surrounds the second electrically conductive wire 14.. The second electrically conductive sheath 107 has a second predefined resistance. The second predefined resistance is different to, the first predefined resistance of the first electrically conductive sheath 7.

In the measurement circuit 15 of the cable assembly 320, the memory 17 stores two predefined threshold resistance values; specifically, the memory 17 stores a first predefined threshold resistance value (R1_{threshold}), a second predefined threshold resistance value (R2_{threshold}). The memory 17 also stores a first predefined resistance change (R_{inc1}) and a second predefined resistance change (R_{inc2}). The first predefined resistance change R_{inc1} is the change in the resistance of the main lead 3 and auxiliary lead 5, between the second and third nodes 19a,19b when a break occurs in the first electrically conductive wire 4.

The first predefined resistance change (R_{inc1}) could be determined in a calibration step which uses a test cable assembly similar to the cable assembly 320, and wherein a break is formed in the first electrically conductive wire 4 of the test cable assembly and the change in resistance of the main lead 3 and auxiliary lead 5 between the second and third nodes 19a,19b is measured.

The second predefined resistance change (R_{inc2}), is a maximum tolerable resistance change. The resistance change of the main lead 3 and auxiliary lead 5 between the second and third nodes 19a,19b is proportional to the extent of damage to the main lead and auxiliary lead (in particular to the extent of damage done to the first and second electrically conductive wires 4,14 and/or to the first and second electrically conductive sheaths 7,107; for example the number of breaks to the electrically conductive wires 4,14, and extent of damage to the electrically conductive sheaths 7,107). The larger the extent of damage the larger the resulting resistance change. The second predefined resistance change (R_{inc2}) enables to set the extent of damage which is tolerable - in applications in which a lot of damage to the main lead and auxiliary lead is acceptable the second predefined resistance change (R_{inc2}) may be set higher compared to applications in which only little damage to the main lead and auxiliary lead is acceptable. The second predefined resistance change (R_{inc2}) may be selected by a user depending on the application in which the cable assembly 320 is used.

In the cable assembly 320, when a break occurs in the first electrically conductive wire 4, the first electrically conductive wire 4 will be broken into two pieces with a gap between the two wire pieces; the first electrically conductive sheath 7 will provide electrical connection between the two pieces of wire: specifically an electrical signal can be conducted from one of the two pieces of wire to the other via the first electrically conductive sheath 7. In this way the main lead 3 can continue to conduct electrical signals; however the conduction of the electrical signals between the two pieces of wire via the electrically conductive sheath 7 gives rise to the first predefined resistance change (R_{inc1}). When there is substantial damage to the main lead 3 (e.g. when multiple breaks in the first electrically conductive wire 4 occur, and/or when a break in the first electrically conductive wire 4 occurs and a break in the first electrically conductive sheath 7 occurs at the same location as the break in the first electrically conductive wire 4) this may lead to a large change in the resistance which may exceed the second predefined resistance change (R_{inc2})).

In one embodiment the first predefined threshold resistance value (R1_{threshold}) is at least equal to the resistance of the main lead 3 and auxiliary lead 5 between the second and third nodes 19a,19b, when there is no break in either of the first electrically conductive wire 4 or second electrically conductive wire 14, plus the first predefined resistance change (R_{inc1}). In one embodiment the first predefined threshold resistance value (R1_{threshold}) is at least equal to the resistance of the main lead 3 and auxiliary lead 5 between the second and third nodes 19a,19b, when there is no break in either of the first electrically conductive wire 4 or second electrically conductive wire 14, plus the first predefined resistance change (R_{inc1}), plus a resistance margin to allow for tolerance of slight variations in measurements and noise etc. (in other words the first predefined threshold resistance value (R1_{threshold}) may be slightly larger (e.g. 1-2% larger) than the resistance of the main lead 3 and auxiliary lead 5 between the second and third nodes 19a,19b, when there is no break in either of the first electrically conductive wire 4 or second electrically conductive wire 14, plus the first predefined resistance change (R_{inc1}). The first predefined threshold resistance value (R1_{threshold}) may be determined in a calibration step in which the resistance of the main lead 3 and auxiliary lead 5 between the second and third nodes 19a,19b, is measured prior to use (to be sure that there is no break in either of the main lead 3 or auxiliary lead 5) of the cable assembly 320. The first predefined resistance change (R_{inc1}) plus optionally a margin (e.g. 1-2%) may be added to said measured resistance to give the value for the first predefined threshold resistance value (R1_{threshold}).

In one embodiment, the second predefined threshold resistance value (R2_{threshold}) is at least equal to the resistance of the main lead 3 and auxiliary lead 5 between the second and third nodes 19a,19b, when there is no break in either of the first electrically conductive wire 4 or second electrically conductive wire 14, plus the second predefined resistance change (R_{inc2}). In one embodiment the second predefined threshold resistance value (R2_{threshold}) is at least equal to the resistance of the main lead 3 and auxiliary lead 5 between the second and third nodes 19a,19b, when there is no break in either of the first electrically conductive wire 4 or second electrically conductive wire 14, plus the second predefined resistance change (R_{inc2}), plus a resistance margin to allow for tolerance of slight variations in measurements and noise etc. (in other words the first predefined threshold resistance value (R2_{threshold}) may be slightly larger (e.g. 1-2% larger) than the resistance of the main lead 3 and auxiliary lead 5 between the second and third nodes 19a,19b, when there is no break in either of the first electrically conductive wire 4 or second electrically conductive wire 14, plus the second predefined resistance change (R_{inc2}). The second predefined threshold resistance value (R2_{threshold}) may be determined in a calibration step in which the resistance of the main lead 3 and auxiliary lead 5 between the second and third nodes 19a,19b, is measured prior to use (to be sure that there is no break in either of the main lead 3 or auxiliary lead 5) of the cable assembly 320. The second predefined resistance change (R_{inc2}) plus optionally a margin (e.g. 1-2%) may be added to said measured resistance to give the value for the second predefined threshold resistance value (R2_{threshold}).

In another embodiment the first predefined threshold resistance value (R1_{threshold}) is at least equal to the resistance of the main lead 3, between the first and third nodes 8,19b, when there is no break in the first electrically conductive wire 4, plus the first predefined resistance change (R_{inc1}). In one embodiment the first predefined threshold resistance value (R1_{threshold}) is at least equal to the resistance of the main lead 3, between the first and third nodes 8,19b, when there is no break in the first electrically conductive wire 4, plus the first predefined resistance change (R_{inc1}), plus a resistance margin to allow for tolerance of slight variations in measurements and noise etc. (in other words the first predefined threshold resistance value (R1_{threshold}) may be slightly larger (e.g. 1-2% larger) than the resistance of the main lead 3, between the first and third nodes 8,19b, when there is no break in the first electrically conductive wire 4, plus the first predefined resistance change (R_{inc1}). The first predefined threshold resistance value (R1_{threshold}) may be determined in a calibration step in which the resistance of the main lead 3, between the first and third nodes 8,19b, is measured prior to use (to be sure that there is no break in the main lead 3) of the cable assembly 320. The first predefined resistance change (R_{inc1}) plus optionally a margin (e.g. 1-2%) may be added to said measured resistance to give the value for the first predefined threshold resistance value (R1_{threshold}).

In another embodiment, the second predefined threshold resistance value (R2_{threshold}) is at least equal to the resistance of the main lead 3, between the first and third nodes 8,19b, when there is no break in the first electrically conductive wire 4, plus the second predefined resistance change (R_{inc2}). In one embodiment the second predefined threshold resistance value (R2_{threshold}) is at least equal to the resistance of the main lead 3, between the first and third nodes 8,19b, when there is no break in the first electrically conductive wire 4, plus the second predefined resistance change (R_{inc2}), plus a resistance margin to allow for tolerance of slight variations in measurements and noise etc. (in other words the first predefined threshold resistance value (R2_{threshold}) may be slightly larger (e.g. 1-2% larger) than the resistance of the main lead 3, between the first and third nodes 8,19b, when there is no break in the first electrically conductive wire 4, plus the second predefined resistance change (R_{inc2}). The second predefined threshold resistance value (R2_{threshold}) may be determined in a calibration step in which the resistance of the main lead 3, between the first and third nodes 8,19b, is measured prior to use (to be sure that there is no break in the main lead 3) of the cable assembly 320. The second predefined resistance change (R_{inc2}) plus optionally a margin (e.g. 1-2%) may be added to said measured resistance to give the value for the second predefined threshold resistance value (R2_{threshold}).

As already described in detail in the previously described embodiments, the processor 18 may calculate the resistance (R_{measured}) of the main lead 3 and auxiliary lead 5 between the second and third nodes 19a,19b using electrical parameters (V_{measured} and I_{measured} or V_{applied} and I_{measured} or V_{measured} and I_{applied}) which the processor 18 receives from the electronic testing module 16. In another embodiment, the processor 18 may calculate the resistance (R_{measured}) of the main lead 3, between the first and third nodes 8,19b, using electrical parameters (V_{measured} and I_{measured}) which the processor 18 receives from the electronic testing module 16.

The processor 18 is configured to compare the calculated resistance value (R_{measured}) with the first predefined threshold resistance value (R1_{threshold}) which is stored in the memory 14. If the calculated resistance value (R_{measured}) is equal to or less than first predefined threshold resistance value (R1_{threshold}) this indicates that there is no break or no additional break in either of the first electrically conductive wire 4 or second electrically conductive wire 14.

Optionally the processor 18 may be further configured to issue an assurance signal e.g. "cable fully intact", at the output 21, if the calculated resistance (R_{measured}) is smaller than the first predefined threshold resistance value (R1_{threshold}).

The processor 18 is further configured to, compare the determined resistance value (R_{measured}) with the second predefined threshold resistance value (R2_{threshold}) if the determined resistance value (R_{measured}) is greater than the first predefined threshold resistance value (R1_{threshold}).

The processor 18 is configured to issue a first alarm signal (preferably at the output 21) if the calculated resistance (R_{measured}) is greater than the first predefined threshold resistance value (R1_{threshold}) and the calculated resistance (R_{measured}) is less than the second predefined threshold resistance value (R2_{threshold}). If the calculated resistance (R_{measured}) is greater than the first predefined threshold resistance value (R1_{threshold}) and is less than the second predefined threshold resistance value (R2_{threshold}), this indicates that there is either a break in the first electrically conductive wire 4 or a break in the second electrically conductive wire 14 . At the location of the break, the first electrically conductive wire 4 will be in two pieces typically with a gap between the two pieces; the first electrically conductive sheath 7 is providing electrical connection between said two pieces of the first electrically conductive wire 4 at the location of the break. Thus, the first alarm signal signifies that there may be a break in the first electrically conductive wire 4 of the main lead 3, but that the main lead 3 is still useable in its current application (i.e. the break is tolerable).

The processor 18 may be further configured to update the first predefined threshold resistance value (R1_{threshold}) and the second predefined threshold resistance value (R2_{threshold}) stored in the memory 17 of the measurement circuit 15, if the calculated resistance (R_{measured}) is greater than the first predefined threshold resistance value (R1_{threshold}) and the calculated resistance (R_{measured}) is less than the second predefined threshold resistance value (R2_{threshold}): Specifically, the processor 18 is configured to update the first predefined threshold resistance value (R1_{threshold}) stored in the memory 17 to be equal to the "calculated resistance (R_{measured}) + the first predefined resistance change (R_{inc1})"; the processor 18 is configured to update the second predefined threshold resistance value (R2_{threshold}) stored in the memory 17 to be equal to the "calculated resistance (R_{measured}) + the second predefined resistance change (R_{inc2})".

The processor 18 is configured to issue a second alarm signal (preferably at the output 21) if the calculated resistance (R_{measured}) is greater than the first predefined threshold resistance value (R1_{threshold}) and the calculated resistance (R_{measured}) is greater than the second predefined threshold resistance value (R2_{threshold}). If the calculated resistance (R_{measured}) is greater than the first predefined threshold resistance value (R1_{threshold}) and the calculated resistance (R_{measured}) is greater than the second predefined threshold resistance value (R2_{threshold}), this indicates that the main lead (or auxiliary lead) has suffered an intolerable extent of damage (e.g. too many breaks in the first electrically conductive wire 4). Thus the second alarm signal indicates that that the main lead (or auxiliary lead) has suffered an intolerable extent of damage. Typically under these circumstances the cable assembly 320, or at least the main lead 3 and auxiliary lead 5 of the cable assembly 320 should be replaced.

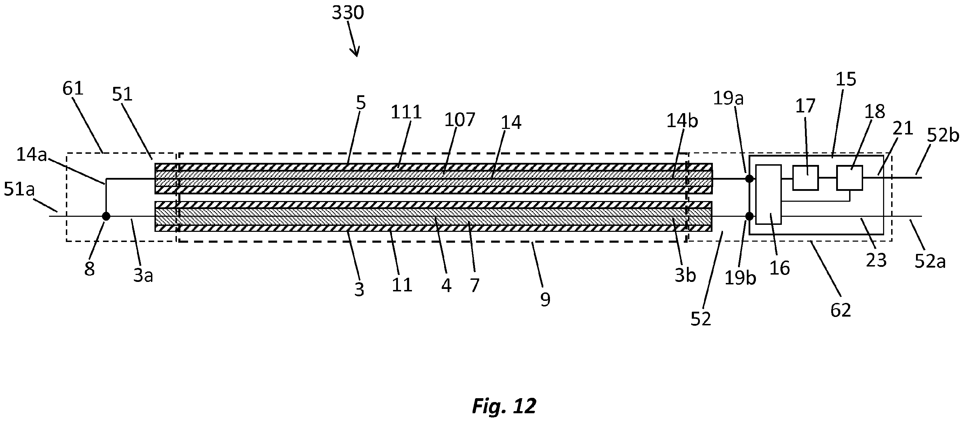

Figure 12 shows a longitudinal section view of a cable assembly 330 according to a further embodiment of the present invention. The cable assembly 330 has many of the same features as the cable assembly 320 shown in Figure 11 and like features are awarded the same reference numbers.

The cable assembly 330 further comprises a first plug member 51 and a second plug member 52. The first plug member 51 comprises a first electrical contact 51a; the second plug member 52 comprises a first electrical contact 52a and a second electrical contact 52b.

The first electrically conductive wire 4 extends between first plug member 51 and the second plug member 52; the first end portion 3a of said first electrically conductive wire 4 is connected to the first electrical contact 51a of the first plug member 51; the second, opposite, end portion 3b of said first electrically conductive wire 4 and the second opposite end portion 14b of the second electrically conductive wire 14b are each respectively connected to the electronic testing module 16. The main lead contact 23 of the measurement circuit 15 is electrically connected to the first electrical contact 52a of the second plug member 52 (thus the first electrically conductive wire 4 can electrically connect the first and second plug members 51,52). The output 21 of the measurement circuit 15 is electrically connected to the second electrical contact 52b of the second plug member 52.

In this example the first and second plug members 51,52 each comprise a rigid housing 61,62 (however it should be understood that it not essential that the housings 61,62 be rigid).

In the cable assembly 330 the measurement circuit 15 is housed in the second plug member 52. Specifically the measurement circuit 15 is housed within rigid housing 62 of the second plug member 52. Accordingly, the second end portion 3b of the first electrically conductive wire 4 is electrically connected to the measurement circuit 15 within the housing 62 of the second plug member 52; likewise the second end portion 14b of the second electrically conductive wire 14 is electrically connected to the measurement circuit 15 within the housing 61 of the second plug member 52.

The first node 8 is housed within the first plug member 51. In this example the first node 8 is housed within rigid housing 61 of the first plug member 51. The second electrically conductive wire 14 extends from the first node 8 to the second plug member 52.

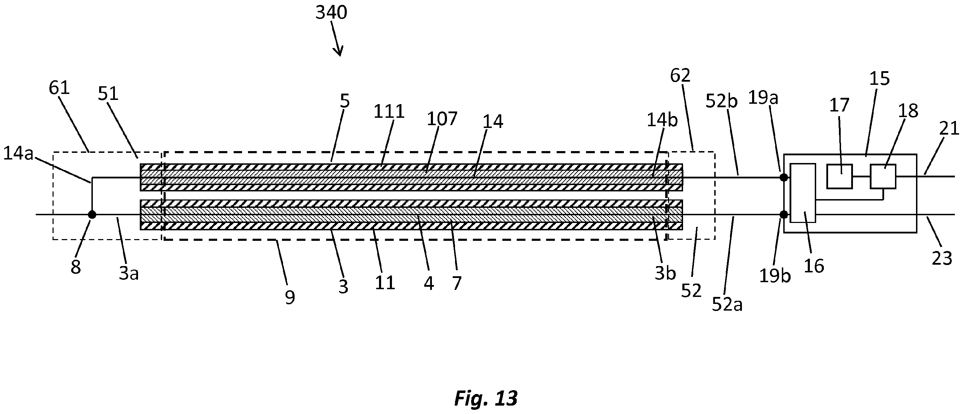

Figure 13 shows a longitudinal section view of a cable assembly 340 according to a further embodiment of the present invention.

The cable assembly 340 has many of the same features as the cable assembly 330 shown in Figure 12 and like features are awarded the same reference numbers.

Unlike the cable assembly 330 shown in Figure 12, in the cable assembly 340 the measurement circuit 15 is arranged external to the second plug member 52. The second plug member 52 can be selectively electrically connected to (e.g. plugged into, or unplugged from), the measurement circuit 15. Figure 13 illustrates the cable assembly 340 wherein the second plug member 52 is arranged to be connected to the measurement circuit 15.

The first electrically conductive wire 4 extends between first plug member 51 and the second plug member 52. The first end portion 3a of said first electrically conductive wire 4 is connected to the first electrical contact 51a of the first plug member 51 and a second, opposite, end portion 3b of said first electrically conductive wire 4 is connected to the first electrical contact 52a of the second plug member 52, so that said first electrically conductive wire 4 electrically connects the first and second plug members 51,52.

The first node 8 is housed within the first plug member 51. Preferably first node 8 is housed within rigid housing 61 of the first plug member 51. The second electrically conductive wire 14 extends from the first node 8 to the second plug member 52.

In the cable assembly 340 the second opposite end portion 14b of the second electrically conductive wire 14 is connected to a second electrical contact 52b of the second plug member 52.

The second plug member 52 can be selectively arranged to be electrically connected to the measurement circuit 15 for example by plugging the second plug member 52 into the measurement circuit 15 as is the case in the present example (in another example the second plug member 52 can arranged to be electrically connected to the measurement circuit 15 by a soldered connection); in this example the second plug member 52 can be selectively arranged to be unplugged from the measurement circuit 15 thereby disconnecting the second plug member 52 from the measurement circuit 15. Figure 13 shows when the second plug member 52 plugged into the measurement circuit 15; the first electrical contact 52a of the second plug member 52 is electrically connected to the second node 19a of the measurement circuit 15; and the second electrical contact 52b of the second plug member 52 is electrically connected to the third node 19b of the measurement circuit 15. Thus the main lead 3 (specifically the first electrically conductive wire 4) is electrically connected to the measurement circuit 15 via the second electrical contact 52b of the second plug member 52; and the auxiliary lead 5 (specifically the second electrically conductive wire 14) is electrically connected to the measurement circuit 15 via the first electrical contact 52a of the second plug member 52.

Thus in this cable assembly 340 embodiment the measurement circuit 15 is arranged external to the second plug member 52, and the main lead 3 and the auxiliary lead 5 are each electrically connected to the measurement circuit 15 via the second plug member 52 when the second plug member 52 is arranged to be connected to the measurement circuit 15.

It should be understood that in a further variation of any of the cable assemblies 1,10,50,150,160, embodiments described above, the second electrically conductive wire 14 of the auxiliary lead 5 of that cable assembly may further comprise a second electrically conductive sheath. The second electrically conductive sheath is configured to have a second predefined resistance which is different to the first predefined resistance of the first electrically conductive sheath 7 provided on the first electrically conductive wire 4 of the main lead 3.

In one embodiment, the difference between the first predefined resistance and the second predefined resistance may be achieved by providing a thickness of the first electrically conductive sheath 7 which is different from the thickness of the second electrically conductive sheath. For example, the thickness of the second electrically conductive sheath may be half of the thickness of the first electrically conductive sheath. In another embodiment, the thickness of the second electrically conductive sheath may be 90% of the thickness of the first electrically conductive sheath.

In one embodiment, the difference between the first predefined resistance and the second predefined resistance may be achieved by providing a first electrically conductive sheath which has a density of electrically conductive elements different to the density of electrically conductive elements in the second electrically conductive sheath. For example, the density of electrically conductive elements of the second electrically conductive sheath may be 90% of the density of electrically conductive elements of the first electrically conductive sheath.

The second electrically conducting sheath may comprise a matrix, and a plurality of electrically conductive elements at least some of which are both partially embedded the matrix and are in mechanical and electrical contact with said second electrically conductive wire 14, and wherein said plurality of electrically conductive elements are electrically connected to one another within the matrix. An electrically conductive element may be electrically connected to another electrically conductive element by said two electrically conductive elements arranged to physically touch each other within the matrix; for example the portion of one of the electrically conductive element which is embedded in the matrix may physically contact the portion of the other electrically conductive element which is embedded within the matrix so that the two electrically conductive elements physically touch each other within the matrix. Alternatively, or additionally, an electrically conductive element may be electrically connected to another electrically conductive element via one or more other electrically conductive element(s) each of the one or more other electrically conductive element(s) being in electrical connection with said two electrically conductive elements. For example a first electrically conductive element may be in physical contact, within the matrix, with a second electrically conductive element, the second electrically conductive element may be in physical contact, within the matrix, with a third electrically conductive element, the third electrically conductive element may be in physical contact, within the matrix, with a fourth electrically conductive element, so that the first and fourth electrically conductive element are electrically connected via the second and third electrically conductive elements. In this case, one possible way to achieve the first predefined resistance being different to the second predefined resistance, is by having density of the electrically conductive elements in the matrix of the first electrically conductive sheath different to the density of the electrically conductive elements in the matrix of the second electrically conductive sheath. Another way to achieve the first predefined resistance being different to the second predefined resistance, is by providing a first electrically conductive sheath which has a different thickness to the thickness of the second electrically conductive sheath.

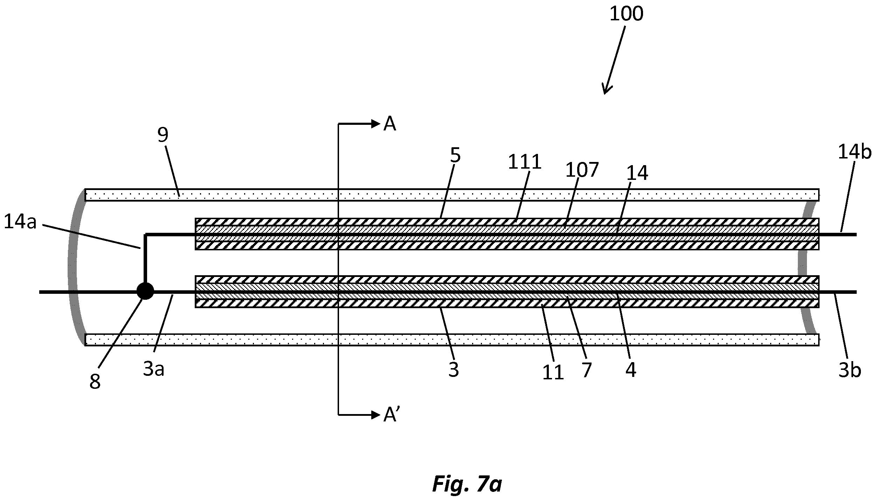

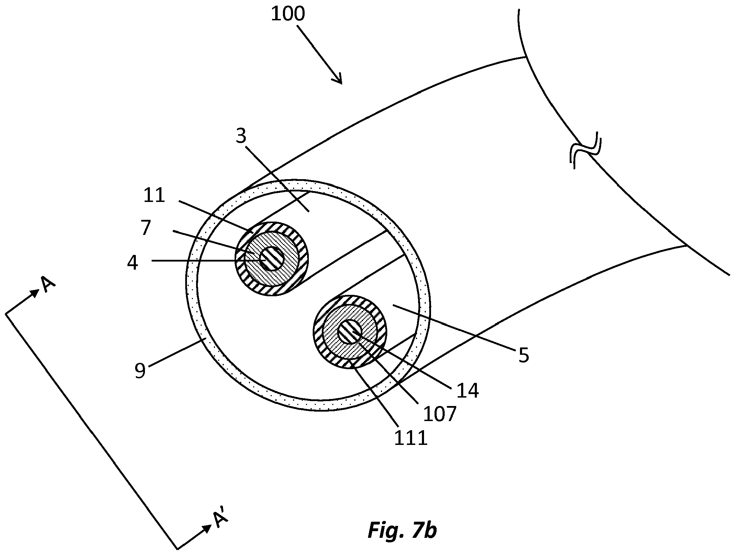

Figure 7a shows a longitudinal section view of a cable assembly 100 according to a further embodiment of the present invention; Figure 7b shows a cross sectional view of the cable assembly 100 taken along line A-A' of Figure 7a. The cable assembly 100 has many of the same features as the cable assembly 1 shown in Figure 1 and like features are awarded the same reference numbers.

In the cable assembly 100 the auxiliary lead 5 further comprises a second electrically conductive sheath 107 which surrounds the second electrically conductive wire 14. Importantly, the second electrically conductive sheath 107 has a second predefined resistance which is different to the first predefined resistance of the first electrically conductive sheath 7 provided on the first electrically conductive wire 4 of the main lead 3. In yet a further variation of this embodiment the first predefined resistance may be larger than the second predefined resistance (i.e. the first electrically conductive sheath may have a larger resistance than the resistance of the second electrically conductive sheath).

In this particular embodiment the first predefined resistance is smaller than the second predefined resistance; in other words in this embodiment the second electrically conductive sheath 107 is configured to have a larger resistance than the resistance of the first electrically conductive sheath 7.

The second electrically conducting sheath 107 comprises a matrix, and a plurality of electrically conductive elements at least some of which are both partially embedded the matrix and are in mechanical and electrical contact with said second electrically conductive wire 14, and wherein said plurality of electrically conductive elements are electrically connected to one another within the matrix. An electrically conductive element may be electrically connected to another electrically conductive element by said two electrically conductive elements arranged to physically touch each other within the matrix; for example the portion of one of the electrically conductive element which is embedded in the matrix may physically contact the portion of the other electrically conductive element which is embedded within the matrix so that the two electrically conductive elements physically touch each other within the matrix. Alternatively, or additionally, an electrically conductive element may be electrically connected to another electrically conductive element via one or more other electrically conductive element(s) each of the one or more other electrically conductive element(s) being in electrical connection with said two electrically conductive elements. For example a first electrically conductive element may be in physical contact, within the matrix, with a second electrically conductive element, the second electrically conductive element may be in physical contact, within the matrix, with a third electrically conductive element, the third electrically conductive element may be in physical contact, within the matrix, with a fourth electrically conductive element, so that the first and fourth electrically conductive element are electrically connected via the second and third electrically conductive elements. In this case, one possible way to achieve the first predefined resistance being different to the second predefined resistance, is by having density of the electrically conductive elements in the matrix of the first electrically conductive sheath different to the density of the electrically conductive elements in the matrix of the second electrically conductive sheath. In this particular example the density of the electrically conductive elements in the matrix of the first electrically conductive sheath 7 is larger than the density of the electrically conductive elements in the matrix of the second electrically conductive sheath 107, so that the second electrically conductive sheath 107 has a higher resistance than the first electrically conductive sheath 7.

It should be understood that the present invention is not limited to requiring the first predefined resistance to be smaller than the second predefined resistance;

The main lead 3 further comprises an insulating sheath 111 which covers the second electrically conductive sheath 107, however it should be understood that the insulating sheath 111 is an optional feature.

Advantageously, in this embodiment of the invention, a measurement circuit, which is connected to the main lead 3 and auxiliary lead 5, can exploit the differing resistances of the first and second electrically conductive sheaths 7,107 to distinguish if a detected break has occurred in the first electrically conductive wire 4 or in the second electrically conductive wire 14, since the change of the resistance of the main lead 3 and auxiliary lead 5, between the second and third nodes 19a,19b, will be different depending if a break occurs either in the first electrically conductive wire 4 of the main lead 3, or in the second electrically conductive wire 14 of the auxiliary lead 5.

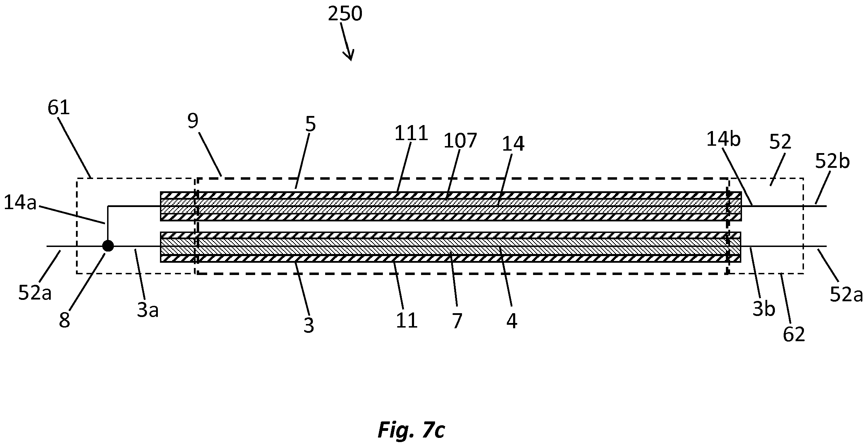

Figure 7c shows a longitudinal section view of a cable assembly 250 according to a further embodiment of the present invention. The cable assembly 250 has many of the same features as the cable assembly 100 according to Figure 7a and 7b and like features are awarded the same reference numbers.

The cable assembly 250 further comprises a first plug member 51 and a second plug member 52. The first electrically conductive wire 4 extends between first plug member 51 and the second plug member 52, the first end portion 3a of said first electrically conductive wire 4 is connected to a first electrical contact 51a of the first plug member 51 and a second, opposite, end portion 3b of said first electrically conductive wire 4 is connected to a first electrical contact 52a of the second plug member 52, so that said first electrically conductive wire 4 electrically connects the first and second plug members 51,52. Most preferably the first and second plug members 51,52 each comprise a rigid housing 61,62.

The first node 8 is housed within the first plug member 51. Preferably the first node 8 is housed within rigid housing 61 of the first plug member 51. The second electrically conductive wire 14 extends from the first node 8 to the second plug member 52.

In the cable assembly 250 the second opposite end portion 14b of the second electrically conductive wire 14 is connected to a second electrical contact 52b of the second plug member 52.

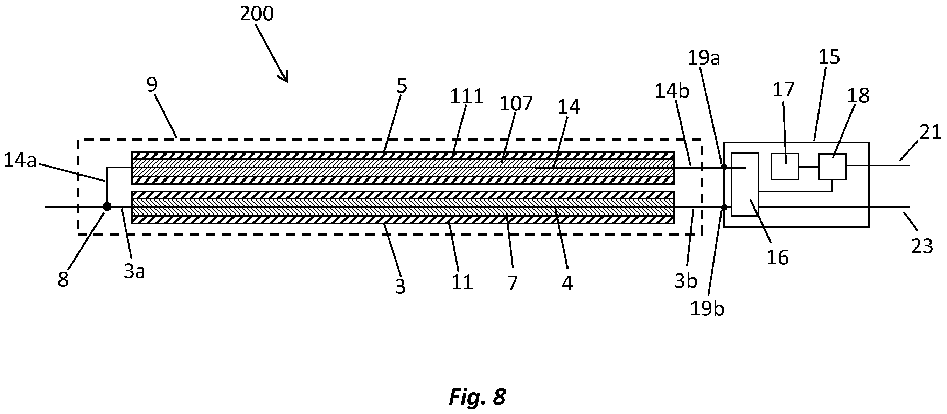

Figure 8 shows a longitudinal section view of a cable assembly 200 according to a further embodiment of the present invention. The cable assembly 200 comprises many of the same features as the cable assembly 10 shown in Figure 2 and like features are awarded the same reference numbers.

In the cable assembly 200 the second electrically conductive wire 14 of the auxiliary lead 5 further comprises a second electrically conductive sheath 107. Importantly, the second electrically conductive sheath 107 has a second predefined resistance which is different to the first predefined resistance of the first electrically conductive sheath 7 provided on the first electrically conductive wire 4 of the main lead 3.

In the measurement circuit 15 of the cable assembly 200, the memory 17 stores three predefined threshold resistance values; specifically, the memory 14 stores a first predefined threshold resistance value (R1_{threshold}), a second predefined threshold resistance value (R2_{threshold}), and a third predefined threshold resistance value (R3_{threshold}). The memory 14 also stores a first predefined resistance change (R_{inc1}) and a second predefined resistance change (R_{inc2}); the first predefined resistance change R_{inc1} is the change in the resistance of the main lead 3 and auxiliary lead 5, between the second and third nodes 19a,19b when a break occurs in the first electrically conductive wire 4; the second predefined resistance change (R_{inc2}), is the change in the resistance of the main lead 3 and auxiliary lead 5 between the second and third nodes 19a,19b when a break occurs in the second electrically conductive wire 14.

In the cable assembly 200, when a break occurs in the first electrically conductive wire 4, the first electrically conductive wire 4 will be broken into two pieces with a gap between the two pieces of wire; the first electrically conductive sheath 7 will provide electrical connection between the two pieces of wire: specifically an electrical signal can be conducted from one of the two pieces of wire to the other via the first electrically conductive sheath 7. In this way the main lead 3 can continue to conduct electrical signals; however the conduction of the electrical signals between the two pieces of wire via the electrically conductive sheath 7 gives rise to the first predefined resistance change (R_{inc1}). Likewise when a break occurs in the second electrically conductive wire 14, the second electrically conductive wire 14 will be broken into two pieces with a gap between the two pieces of wire; the second electrically conductive sheath 107 will provide electrical connection between the two pieces of wire: specifically an electrical signal can be conducted from one of the two pieces of wire to the other via the second electrically conductive sheath 107. In this way the auxiliary lead 5 can continue to conduct electrical signals; however the conduction of the electrical signals between the two pieces of wire via the second electrically conductive sheath 107 gives rise to the second predefined resistance change (R_{inc2}).

In this example since the second electrically conductive sheath 107 is configured to have a higher resistance than the first electrically conductive sheath 7, the second predefined resistance change (R_{inc2}) will be larger than the first predefined resistance change (R_{inc1}). However it should be understood that in another embodiment the first electrically conductive sheath 7 may be configured to have a higher resistance than the second electrically conductive sheath 107, so that the first predefined resistance change (R_{inc1}) will be larger than the second predefined resistance change (R_{inc2}).

The first predefined resistance change (R_{inc1}) could be determined in a calibration step which uses a test cable assembly similar to the cable assembly 200, and wherein a break is formed in the first electrically conductive wire 4 of the test cable assembly and the change in resistance of the main lead 3 and auxiliary lead 5 between the second and third nodes 19a,19b is measured. In other words, a first test resistance of the main lead 3 and auxiliary lead 5 between the second and third nodes 19a,19b is measured prior to forming a break in the conductive wire 4 of the test cable assembly, and a second test resistance of the main lead 3 and auxiliary lead 5 between the second and third nodes 19a,19b is measured after forming a break in the conductive wire 4 of the test cable assembly, and the first predefined resistance change (R_{inc1}) is determined by subtracting the first test resistance from the second test resistance. Similarly, the second predefined resistance change (R_{inc2}) could be determined in a calibration step which uses a test cable assembly similar to the cable assembly 200, and wherein a break is formed in the second electrically conductive wire 14 of the test cable assembly and the change in resistance of the main lead 3 and auxiliary lead 5 between the second and third nodes 19a,19b is measured.

In this embodiment the first predefined threshold resistance value (R1_{threshold}) is at least equal to the resistance of the main lead 3 and auxiliary lead 5 between the second and third nodes 19a,19b, when there is no break in either of the first electrically conductive wire 4 or second electrically conductive wire 14, plus the first predefined resistance change (R_{inc1}). In one embodiment the first predefined threshold resistance value (R1_{threshold}) is at least equal to the resistance of the main lead 3 and auxiliary lead 5 between the second and third nodes 19a,19b, when there is no break in either of the first electrically conductive wire 4 or second electrically conductive wire 14, plus the first predefined resistance change (R_{inc1}), plus a resistance margin to allow for tolerance of slight variations in measurements and noise etc. (in other words the first predefined threshold resistance value (R1_{threshold}) may be slightly larger (e.g. 1-2% larger) than the resistance of the main lead 3 and auxiliary lead 5 between the second and third nodes 19a,19b, when there is no break in either of the first electrically conductive wire 4 or second electrically conductive wire 14, plus the first predefined resistance change (R_{inc1})). The first predefined threshold resistance value (R1_{threshold}) may be determined in a calibration step in which the resistance of the main lead 3 and auxiliary lead 5 between the second and third nodes 19a,19b, is measured prior to use (to be sure there is no break in either of the main lead 3 or auxiliary lead 5) of the cable assembly 200. The first predefined resistance change (R_{inc1}) plus optionally a margin (e.g. 1-2%) may be added to said measured resistance to give the value for the first predefined threshold resistance value (R1_{threshold}).

The second predefined threshold resistance value (R2_{threshold}) is at least equal to the resistance of the main lead 3 and auxiliary lead 5 between the second and third nodes 19a,19b, when there is no break in either of the first electrically conductive wire 4 or second electrically conductive wire 14, plus the second predefined resistance change (R_{inc2}). In one embodiment the second predefined threshold resistance value (R2_{threshold}) is at least equal to the resistance of the main lead 3 and auxiliary lead 5 between the second and third nodes 19a,19b, when there is no break in either of the first electrically conductive wire 4 or second electrically conductive wire 14, plus the second predefined resistance change (R_{inc2}), plus a resistance margin to allow for tolerance of slight variations in measurements and noise etc. (in other words the second predefined threshold resistance value (R2_{threshold}) may be slightly larger (e.g. 1-2% larger) than the resistance of the main lead 3 and auxiliary lead 5 between the second and third nodes 19a,19b, when there is no break in either of the first electrically conductive wire 4 or second electrically conductive wire 14, plus the second predefined resistance change (R_{inc2})). The second predefined threshold resistance value (R2_{threshold}) may be determined in a calibration step in which the resistance of the main lead 3 and auxiliary lead 5 between the second and third nodes 19a,19b, is measured prior to use (to be sure there is no break in either of the main lead 3 or auxiliary lead 5) of the cable assembly 200. The second predefined resistance change (R_{inc2}) plus a margin (e.g. 1-2%) may be added to said measured resistance to give the value for the first predefined threshold resistance value (R1_{threshold}).

The third predefined threshold resistance value (R3_{threshold}) is at least equal to the second predefined threshold resistance value (R2threshold). In general, R3threshold is equal to the maximum tolerable resistance of the main lead and its value depends on the application in which the cable assembly 200 is used.

As already described in detail in the previously described embodiments, the processor 18 calculates the resistance (R_{measured}) of the main lead 3 and auxiliary lead 5 between the second and third nodes 19a,19b using electrical parameters (V_{measured} and I_{measured} or V_{applied} and I_{measured} or V_{measured} and I_{applied}) which the processor 18 receives from the electronic testing module 16.

The processor 18 is configured to compare the calculated resistance value (R_{measured}) with the first predefined threshold resistance value (R1_{threshold}) which is stored in the memory 14. If the calculated resistance value (R_{measured}) is equal to or less than first predefined threshold resistance value (R1_{threshold}) this indicates that there is no break or no additional break in either of the first electrically conductive wire 4 or second electrically conductive wire 14.

Optionally the processor 18 may be further configured to issue an assurance signal e.g. "cable fully intact", at the output 21, if the calculated resistance (R_{measured}) is less than the first predefined threshold resistance value (R1_{threshold}).

The processor 18 is further configured to, compare the determined resistance value (R_{measured}) with the second predefined threshold resistance value (R2_{threshold}) if the determined resistance value (R_{measured}) greater than the first predefined threshold resistance value (R1_{threshold}).

The processor 18 is configured to issue a first alarm signal (preferably at the output 21) if the calculated resistance (R_{measured}) is greater than the first predefined threshold resistance value (R1_{threshold}) and the calculated resistance (R_{measured}) is less than the second predefined threshold resistance value (R2_{threshold}). If the calculated resistance (R_{measured}) is greater than the first predefined threshold resistance value (R1_{threshold}) and is less than the second predefined threshold resistance value (R2_{threshold}), this indicates that there is a break in the first electrically conductive wire 4 (but no break in the second electrically conductive wire 14). At the location of the break, the first electrically conductive wire 4 will be in two pieces typically with a gap between the two pieces; the first electrically conductive sheath 7 is providing electrical connection between said two pieces of the first electrically conductive wire 4 at the location of the break. Thus, the first alarm signal signifies that there is a break in the first electrically conductive wire 4 of the main lead 3, but that the main lead 3 is still useable in its current application (i.e. the break is tolerable).

The processor 18 may be further configured to update the first predefined threshold resistance value (R1_{threshold}) and the second predefined threshold resistance value (R2_{threshold}) stored in the memory 17 of the measurement circuit 15, if the calculated resistance (R_{measured}) is greater than the first predefined threshold resistance value (R1_{threshold}) and the calculated resistance (R_{measured}) is less than the second predefined threshold resistance value (R2_{threshold}): Specifically, the processor 18 is configured to update the first predefined threshold resistance value (R1_{threshold}) stored in the memory 17 to be equal to the "calculated resistance (R_{measured}) + the first predefined resistance change (R_{inc1})"; the processor 18 is configured to update the second predefined threshold resistance value (R2_{threshold}) stored in the memory 17 to be equal to the "calculated resistance (R_{measured}) + the second predefined resistance change (R_{inc2})".

The processor 15 is further programmed to compare the determined resistance value (R_{measured}) with the third predefined threshold resistance value (R3_{threshold}) if the determined resistance value (R_{measured}) is greater than the first predefined threshold resistance value (R1_{threshold}) and is greater than the second predefined threshold resistance value (R2_{threshold}).

The processor 18 is configured to issue (preferably at the output 21) a second alarm signal (which preferably is different to the first alarm signal) if the calculated resistance (R_{measured}) is greater than the third predefined threshold resistance value (R3_{threshold})). If the calculated resistance value (R_{measured}) is greater than the third predefined threshold resistance value (R3_{threshold}) (and also greater than the first predefined threshold resistance value (R1_{threshold}) and the second predefined threshold resistance value (R2_{threshold})), this indicates that the main lead 3 and/or the auxiliary lead 5 have been damaged to an intolerable extent. Thus the second alarm signal indicates that the main lead 3 and/or the auxiliary lead 5 have been damaged to an intolerable extent. Typically under these circumstances the cable assembly 200, or at least the main lead 3 and/or auxiliary lead 5 should be replaced.

The processor 18 is configured to issue (preferably at the output 21) a third alarm signal (which preferably is different to the first and second alarm signals) if the calculated resistance (R_{measured}) is greater than the first predefined threshold resistance value (R1_{threshold}), and greater than the second predefined threshold resistance value (R2_{threshold}), but is less than third predefined threshold resistance value (R3_{threshold}). If the calculated resistance (R_{measured}) is greater than the first predefined threshold resistance value (R1_{threshold}), and greater than the second predefined threshold resistance value (R2_{threshold}), but is less than third predefined threshold resistance value (R3_{threshold}), this indicates that that there is a break in the second electrically conductive wire 14 but no break in the first electrically conductive wire 4. Thus the third alarm indicates that that there is a break in the second electrically conductive wire 14 but no break in the first electrically conductive wire 4, so that the main lead 3 is still useable in its current application (i.e. the break is tolerable).

The processor 18 may be further configured to update the first predefined threshold resistance value (R1_{threshold}) and the second predefined threshold resistance value (R2_{threshold}) stored in the memory 17, if the calculated resistance (R_{measured}) is greater than the first predefined threshold resistance value (R1_{threshold}) and is greater than the second predefined threshold resistance value (R2_{threshold}), and the calculated resistance (R_{measured}) is less than the third predefined threshold resistance value (R3_{threshold}): Specifically, the processor 18 is configured to update the first predefined threshold resistance value (R1_{threshold}) stored in the memory 17 to be equal to the "calculated resistance (R_{measured}) + the first predefined resistance change (R_{inc1})"; the processor 18 is configured to update the second predefined threshold resistance value (R2_{threshold}) stored in the memory 17 to be equal to the "calculated resistance (R_{measured}) + the second predefined resistance change (R_{inc2})".

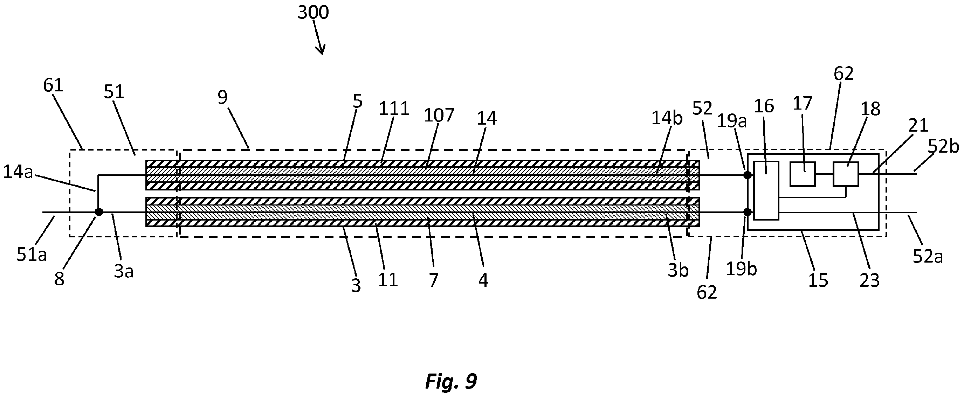

Figure 9 shows a longitudinal section view of a cable assembly 300 according to a further embodiment of the present invention. The cable assembly 300 has many of the same features as the cable assembly 200 shown in Figure 8 and like features are awarded the same reference numbers.

The cable assembly 300 further comprises a first plug member 51 and a second plug member 52. The first electrically conductive wire 4 extends between first plug member 51 and the second plug member 52, the first end portion 3a of said first electrically conductive wire 4 is connected to a first electrical contact 51a of the first plug member 51; the second, opposite, end portion 3b of said first electrically conductive wire 4 and the second opposite end portion 14b of the second electrically conductive wire 14b is connected to the electronic testing module 16. The main lead contact 23 of the measurement circuit 15 is electrically connected to the first electrical contact 52a of the second plug member 52 (thus the first electrically conductive wire 4 can electrically connect the first and second plug members 51,52). The output 21 of the measurement circuit 15 may be electrically connected to the second electrical contact 52b of the second plug member 52 (in an alternative embodiment for example the output 21 of the measurement circuit 15 may be connected to an LED provided in the second plug member 52).

In this example the first and second plug members 51,52 each comprise a rigid housing 61,62 (however it should be understood that it not essential that the housings 61,62 be rigid).

In the cable assembly 300 the measurement circuit 15 is housed in the second plug member 52. Specifically the measurement circuit 15 is housed within rigid housing 62 of the second plug member 52. Accordingly, the second end portion 3b of the first electrically conductive wire 4 is electrically connected to the measurement circuit 15 within the housing 62 of the second plug member 52; likewise the second end portion 14b of the second electrically conductive wire 14 is electrically connected to the measurement circuit 15 within the housing 61 of the second plug member 52.

The first node 8 is housed within the first plug member 51. In this example the first node 8 is housed within rigid housing 61 of the first plug member 51. The second electrically conductive wire 14 extends from the first node 8 to the second plug member 52.

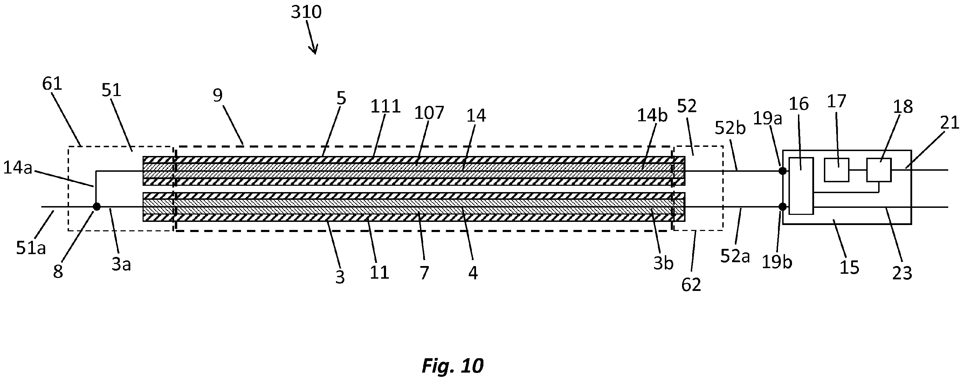

Figure 10 shows a longitudinal section view of a cable assembly 310 according to a further embodiment of the present invention.

The cable assembly 310 has many of the same features as the cable assembly 300 shown in Figure 9 and like features are awarded the same reference numbers.

Unlike the cable assembly 300 shown in Figure 9 in the cable assembly 310 the measurement circuit 15 is arranged external to the second plug member 52. The second plug member 52 can be selectively electrically connected to (for example plugged into, or unplugged from), the measurement circuit 15. Figure 10 illustrates the cable assembly 310 wherein the second plug member 52 is arranged to be connected to the measurement circuit 15.

The first electrically conductive wire 4 extends between first plug member 51 and the second plug member 52, the first end portion 3a of said first electrically conductive wire 4 is connected to a first electrical contact 51a of the first plug member 51 and a second, opposite, end portion 3b of said first electrically conductive wire 4 is connected to a first electrical contact 52a of the second plug member 52, so that said first electrically conductive wire 4 electrically connects the first and second plug members 51,52.

The first node 8 is housed within the first plug member 51. Preferably first node 8 is housed within rigid housing 61 of the first plug member 51. The second electrically conductive wire 14 extends from the first node 8 to the second plug member 52.

In the cable assembly 310 the second opposite end portion 14b of the second electrically conductive wire 14 is connected to a second electrical contact 52b of the second plug member 52.

The second plug member 52 can be selectively arranged to be electrically connected to the measurement circuit 15 by electrically connecting (e.g. plugging) the second plug member 52 into the measurement circuit 15; the second plug member 52 can be selectively arranged to be disconnected from the measurement circuit 15 by disconnecting (e.g. unplugging) the second plug member 52 from the measurement circuit 15. Figure 10 shows that when the second plug member 52 is plugged into the measurement circuit 15; the first electrical contact 52a of the second plug member 52 is electrically connected to the second node 19a of the measurement circuit 15; and the second electrical contact 52b of the second plug member 52 is electrically connected to the third node 19b of the measurement circuit 15. Thus the main lead 4 (specifically the first electrically conductive wire 4) is electrically connected to the measurement circuit 15 via the second electrical contact 52b of the second plug member 52; and the auxiliary lead 5 (specifically the second electrically conductive wire 14) is electrically connected to the measurement circuit 15 via the first electrical contact 52a of the second plug member 52.

Thus in this cable assembly 310 embodiment the measurement circuit 15 is arranged external to the second plug member 52, and the main lead 3 and the auxiliary lead 5 are each electrically connected to the measurement circuit 15 via the second plug member 52 when the second plug member 52 is arranged to be plugged into the measurement circuit 15.

Various modifications and variations to the described embodiments of the invention will be apparent to those skilled in the art without departing from the scope of the invention as defined in the appended claims. Although the invention has been described in connection with specific preferred embodiments, it should be understood that the invention as claimed should not be unduly limited to such specific embodiments. For example, it should be understood that in each of the embodiments described above the cable assembly may comprise a plurality of main leads and auxiliary leads each having the same features as the main leads and auxiliary leads of the cable assemblies described in this application. In a further variation the first plug member 51 may comprise a plurality of first electrical contacts 51a each of which is electrically connected to a respective one of the plurality of main leads; and the second plug member 52 may comprise a plurality of first electrical contacts 52a each of which is electrically connected to a respective one of the plurality of main leads, and a plurality of second electrical contacts 52b each of which is electrically connected to a respective one of the plurality of auxiliary leads.

It should be understood that any one of the components of the measurement circuit 15 can be realized by digital circuitry or analogous circuitry, or a combination thereof. For example, the processor 18 can be a numerically computing digital circuit, or consist of analogue devices such as comparators and electrical resistors. Similarly, the memory 17 can be a digital memory bank holding digitally stored threshold values, or the memory 17 may comprise threshold values represented by analogue components, e.g. resistors.

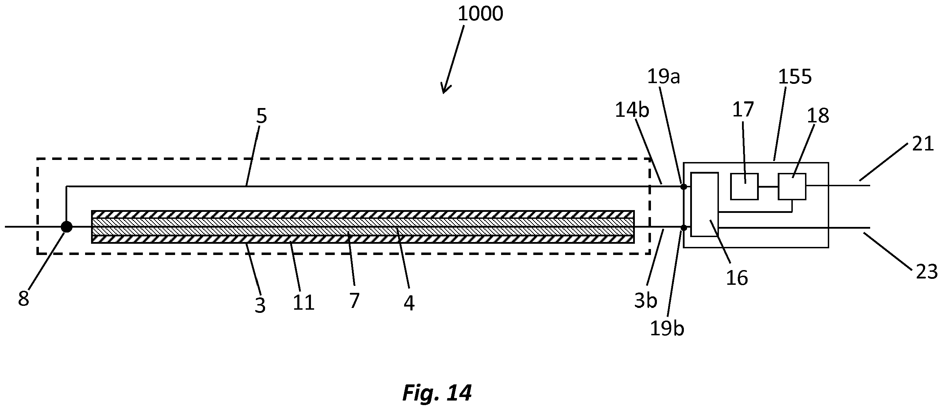

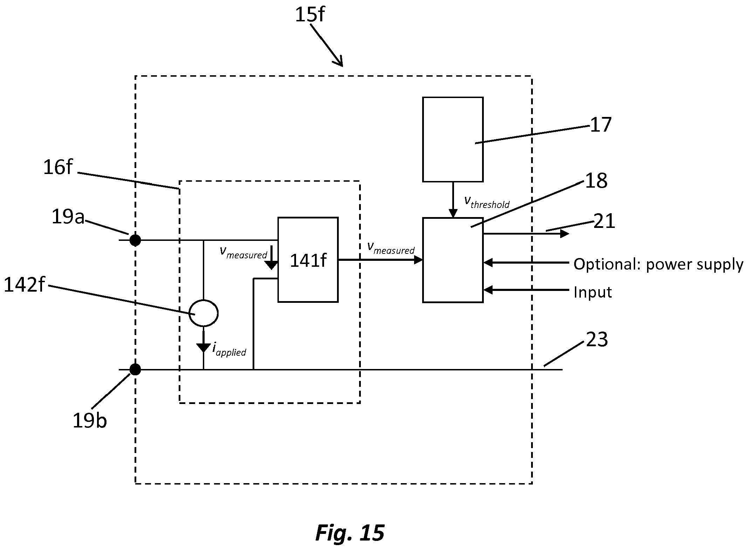

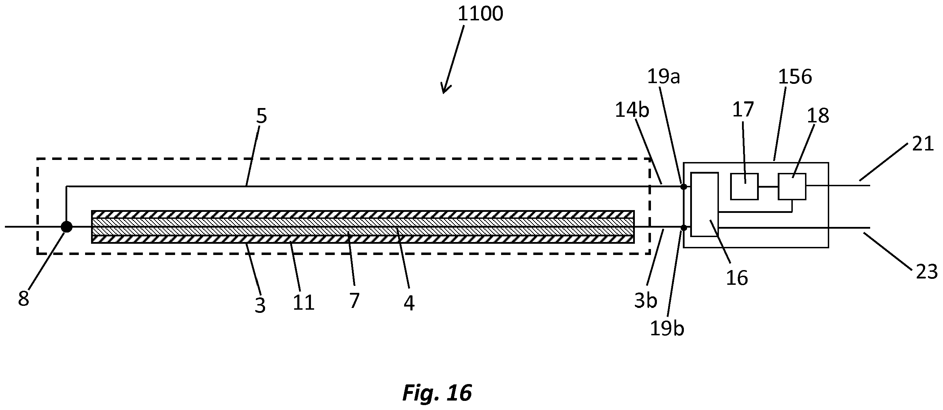

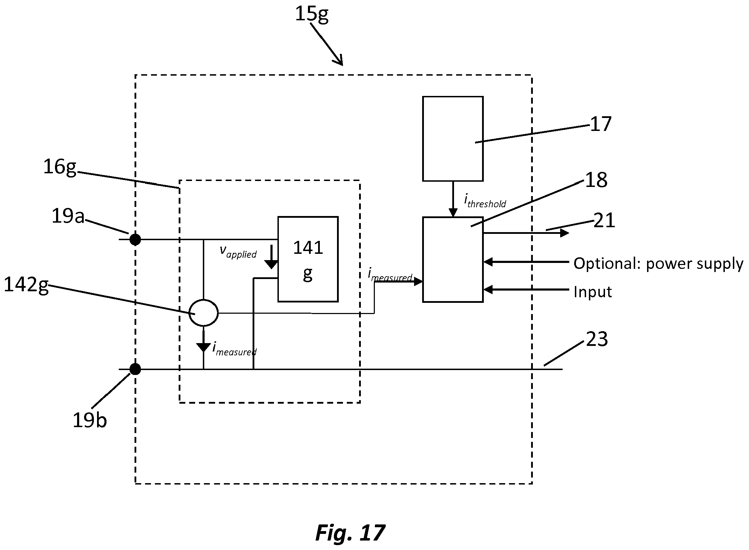

It should be understood that for any of the circuits presented, it may not be necessary to explicitly calculate a resistance value from measured electrical signals, to then compare the calculated value to threshold resistance values. Alternatively, it is for example possible to measure only a voltage when a known current is applied, and then to compare the measured voltage directly to a stored threshold voltage value to determine whether an additional break in a wire of the cable has occurred. Likewise, it is for example possible to measure only a current when a known voltage is applied, and then to compare the measured current directly to a stored threshold current value to determine whether an additional break in a wire of the cable has occurred. Those alternative measurement principles will be exemplified in the cable assembly 1000 shown in Figure 14 and in the measurement circuit embodiment 15f shown in Figure 15, and in the cable assembly 1100 shown in Figure 16 and in the measurement circuit embodiment 15g shown in Figure 17.

Figure 14 shows a longitudinal section view of a cable assembly 1000 according to a further aspect of the present invention. The cable assembly 1000 has many of the same features as the cable assembly 10 shown in Figure 2 and like features are awarded the same reference numbers.

The cable assembly 1000 comprises a measurement circuit 155 which is configured such that it can apply a test current (i_{applied}) through the main lead 3 and the auxiliary lead 5; determine the voltage (v_{measured}) across the main lead 3 and auxiliary lead 5; compare the measured voltage (v_{measured}) to at least a first predefined threshold voltage value (v1_{threshold}). If the determined voltage (v_{measured}) is greater than the first predefined threshold voltage value (v1_{threshold}) then this will indicate that a break has occurred in the first electrically conductive wire 4 of the main lead 3. Most preferably the measurement circuit 15 is configured to issue an alarm if the measured voltage (v_{measured}) is greater than the first predefined threshold voltage value (v1_{threshold}).

It should be understood that the measurement circuit 15 in the cable assembly 1000 may take any suitable configuration which enable the measurement circuit 15 to determine the voltage (v_{measured}) across the main lead 3 and auxiliary lead 5. In cable assembly 1000 the measurement circuit comprises an electronic testing module 16, a memory 17 and a processor 18.

The second end portion 3b of the first electrically conductive wire 4 is connected to the measurement circuit 155 at a second node 19 and the second end portion 14b of the second electrically conductive wire 14 is connected to the measurement circuit 155 at a third node 19b. The electronic testing module 16 is electrically connected to the respective second and third nodes 19a,19b.

The electronic testing module 16 is configured so that it can provide the processor 18 with the measured voltage value (v_{measured}) across the main lead 3 and auxiliary lead 5 between the second and third nodes 19a,19b. As will be described in more detail below, the electronic testing module 16 may comprise a current measuring means configured to, or configurable to, measure the current (I_{measured}) which flows into the third node 19b; the electronic testing module 16 may comprise a current source which is configured to deliver a test current (I_{applied}) to the third node 19b (and thus to the main lead and auxiliary lead); the electronic testing module 16 may comprise a voltage measuring means configured to measure the voltage (V_{measured}) across the second and third nodes 19a,19b (i.e. the voltage across the auxiliary lead 5 and the main lead 3, between the second and third nodes 19a,19b); the electronic testing module 16 may comprise a voltage source configured to apply a test voltage (V_{applied}) across the main lead and auxiliary lead i.e. apply a test voltage across the second and third nodes 19a,19b.

The electronic testing module 16 may be configured such that it can provide the processor 18 with said current measurement (I_{measured}) taken by the current measuring means and/or the level of test current I_{applied}) which the current source delivered, and/or said measured voltage (V_{measured}) taken by the voltage measuring means, and/or the level of test voltage (V_{applied}) which the voltage source applied.

The processor 18 is operably connected to the electronic testing module 16 so that the processor 18 can receive said current and voltage values from the electronic testing module 16.

The memory 17 of the measurement circuit 155 stores at least a first predefined threshold voltage value (v1_{threshold}). The processor 18 is also operably connected to the memory 17 so that the processor 18 can receive said stored at least a first predefined threshold voltage value (v1_{threshold}) from the memory 17.

The processor is further configured to receive said stored first predefined threshold voltage value (v1_{threshold}) from the memory 17 and to compare said measured voltage (V_{measured}) with the first predefined threshold voltage value (v1_{threshold}). If the measured voltage (v_{measured}) is greater than the first predefined threshold voltage value (v1_{threshold}), this indicates that a break has occurred in either the first electrically conductive wire 4 of the main lead 3 or that a break has occurred in the second electrically conductive wire 14 of the auxiliary lead 5.

The processor 18 is configured to issue an alarm if the measured voltage (v_{measured}) is greater than the first predefined threshold voltage value (v1_{threshold}). The alarm may take any suitable form for example the alarm may be a visible alarm signal, e.g. LED, an audible alarm signal, e.g. buzzer, and/or a digital status signal providing information about the health status of the cable assembly, e.g. "main lead broken, replacement is required". Optionally the processor 18 may be further configured to issue an assurance signal e.g. "cable fully intact", if the measured voltage (v_{measured}) is less than the first predefined threshold voltage value (v1_{threshold)}. In this example the measurement circuit 155 further comprises an output 21 (the processor 18 is connected to the output; if the processor is to issue an alarm signal it can provide a signal to the output 21 which will generate the alarm); most preferably the measurement circuit 155 will issue an alarm signal at the output 21 if the measured voltage (v_{measured}) is greater than the first predefined threshold voltage value (v1_{threshold}).

The measurement circuit 155 further comprises a main lead contact 23. The main lead contact 23 is connected (or can be selectively connected) to the first electrically conductive wire 4 of the main lead. The main lead contact 23 can output signals which have been transmitted along the main lead 3; most preferably the main lead contact 23 outputs signals which have been transmitted along the main lead 3 from the first end portion 3a of the main lead 3, to the second end portion 3b of the main lead 3, or the main lead contact 23 acts as an input for signals which are to be transmitted along the main lead 3 from the second end portion 3b of the main lead 3, to the first end portion 3a of the main lead 3. Typically, the main lead contact 23 will be further electrically connected to external circuitry, thus signal(s) transmitted along the main lead 23 from the first end portion 3a of the main lead 3, to the second end portion 3b of the main lead 3 can be sent to the external circuitry via the main lead contact 23, or signal(s) received from the external circuitry can be transmitted along the main lead 23 from the second end portion 3b of the main lead 3, to the first end portion 3a of the main lead 3.

Optionally the memory 17 of the measurement circuit 155 may store a second predefined threshold voltage value (v2_{threshold}). The processor 18 is also operably connected to the memory 17 so that the processor 18 can receive said stored second predefined threshold voltage value (v2_{threshold}) from the memory 17 (the second predefined threshold voltage value (v2_{threshold}) being larger than the first predefined threshold voltage value (v1_{threshold}). Optionally, the processor 18 is further configured to compare said measured voltage (v_{measured}) with the second predefined threshold voltage value (v2_{threshold}) if the measured voltage (v_{measured}) is greater than the first predefined threshold voltage value (v1_{threshold}). If said measured voltage (v_{measured}) is greater than both the first predefined threshold voltage value (v1_{threshold}) and the second predefined threshold voltage value (v2_{threshold}) this indicates that there is an unacceptable number of breaks in the electrically conductive wire 4 or that there is an unacceptable extent of damage to the first electrically conductive wire 4 and the first electrically conductive sheath 7 of the main lead 3 or that there is a break in the second electrically conductive wire 5 of the auxiliary lead; if said measured voltage (v_{measured}) is greater than the first predefined threshold voltage value (v1_{threshold}) but is less than the second predefined threshold voltage value (v2_{threshold}) this indicates that there is one or more breaks in the electrically conductive wire 4 (and also possibly some damage to the first electrically conductive sheath 7) of the main lead 3 but that the number of breaks (and extent of damage) is acceptable. Preferably the processor 18 is configured to issue a first alarm if the measured voltage (v_{measured}) is greater than the first predefined threshold voltage value (v1_{threshold}) and the measured voltage (v_{measured}) is less than the second predefined threshold voltage value (v2_{threshold}); and is configured to issue a second alarm (which is preferably different to the first alarm) if the measured voltage (v_{measured}) is greater than the first predefined threshold voltage value (v1_{threshold}) and the measured voltage (v_{measured}) is greater than the second predefined threshold voltage value (v2_{threshold}).

Preferably, the processor 18 is configured to update the first predefined threshold voltage value (v1_{threshold}) stored in the memory 17, if the measured voltage (v_{measured}) is greater than the first predefined threshold voltage value (v1_{threshold}) and the measured voltage (v_{measured}) is less than the second predefined threshold voltage value (v2_{threshold}). The processor 18 may be configured to update the first predefined threshold voltage value (v1_{threshold}) to be equal to the "measured voltage (v_{measured}) + a predefined first voltage increase value (v_{inc1})" wherein said predefined first voltage increase value (v_{inc1}) is the voltage increase across the main lead 3 which is expected when a break occurs in the first electrically conductive wire 4 of the main lead and a known test current (i_{applied}) is applied through the main lead 3. The measured voltage is proportional to resistance and hence proportional to the number of breaks in the first electrically conductive wire 4 and/or the extent of damage to the first electrically conductive sheath 7 of the main lead 3 and/or the extent of damage to the second electrically conductive wire 14; the predefined maximum voltage v2_{threshold} is the measured voltage (v_{measured}) when a known test current (i_{applied}) is applied through the main lead 3 and the auxiliary lead 5 and when the resistance of the main lead 3 and the auxiliary lead 5 has the maximum tolerable value (which in turn reflects how many breaks and how much damage to the main lead is to be tolerated), and v2_{trehshold} can be chosen depending on the application in which the cable assembly is used.

It should be noted that the predefined first voltage increase value (v_{inc1}) could be determined in a calibration process using a test lead which is similar to the main lead 3, which involves applying a known test current (i_{applied}) to the test lead, measuring a first voltage across the test lead (unbroken), then providing a break in the conductive wire of the test lead and measuring a second voltage across the test lead; then subtracting the first measured voltage from the second measured voltage to determine the predefined first voltage increase value (v_{inc1}).

Figure 15 illustrates one possible implementation for the measurement circuit 155. This example is similar to the measurement circuit 15a shown in Figure 3a, with the main difference that the measured voltage v_{measured} is compared to a threshold value v_{threshold} in order to detect an increase in the series resistance of the main lead 3 and the auxiliary lead 5 between the second node 19a and the third node 19b. In this example the measurement circuit 15f comprises an electronic testing module 16f which comprises a voltage module 141f which is electrically connected to the second node 19a and also electrically connected to the third node 19b. The voltage module 141f comprises a voltage measurement means which can selectively measure the voltage (v_{measured}) across the main lead 3 and auxiliary lead 5 which are connected in series, i.e. measure the voltage (v_{measured}) across the second and third nodes 19a,19b.

The electronic testing module 16f further comprises a current source 142f which is connected to the third node 19b, so that the current source 142f can apply a test current (i_{applied}) to the third node 19b; the applied test current (i_{applied}) will flow into the third node 19b, along the main lead 3 and auxiliary lead 5 and into the second node 19a. The voltage module 141f is configured to measure the voltage (v_{measured}) across the main lead 3 and auxiliary lead 5 which are connected in series (i.e. measure the voltage (v_{measured}) across the second and third nodes 19a,19b) after the current source 142f has applied a test current (i_{applied}) to the third node 19b.

Preferably the processor 18 is configured to control the voltage module 141f and the current source 142f; the processor 18 may be configured to initiate the current source 142f to apply a test current (i_{applied}) to the third node 19b, and to initiate the voltage module 141f to measure the voltage (v_{measured}) (resulting from the test current (i_{applied})) across the main lead 3 and auxiliary lead 5.

The processor 18 is configured to receive from the voltage module 141f said voltage measurement (v_{measured}) taken by the voltage measurement means of the voltage module 141f after the current source 142f applied the test current (i_{applied}). Optionally, the processor 18 may be configured to initiate the current source 142f to stop applying a test current (i_{applied}) to the third node 19b and to initiate the voltage module 141f to stop measuring voltage, after the processor has received said voltage measurement (vmeasured).

The processor 18 is further configured to receive a voltage threshold value v_{threshold} from the memory module 17 and to compare the measured voltage v_{measured} to the voltage threshold value v_{threshold}. If the measured voltage v_{measured} exceeds the voltage threshold value v_{threshold}, this indicates that a break has occurred in the main lead 3 or in the auxiliary lead 5.

Figure 16 shows a longitudinal section view of a cable assembly 1100 according to a further aspect of the present invention. The cable assembly 1100 has many of the same features as the cable assembly 1 shown in Figures 1a and 1b and like features are awarded the same reference numbers.

The cable assembly 1000 comprises a measurement circuit 156 which is configured such that it can apply a test voltage (v_{applied}) across the main lead 3 and the auxiliary lead 5; determine the current (i_{measured}) flowing into node 19b and into the main lead 3; compare the measured current (i_{measured}) to at least a first predefined threshold current value (i1_{threshold}). If the determined current (i_{measured}) is smaller than the first predefined threshold current value (i1_{threshold}) then this will indicate that a break has occurred in the first electrically conductive wire 4 of the main lead 3. Most preferably the measurement circuit 15 is configured to issue an alarm if the measured current (i_{measured}) is smaller than the first predefined threshold current value (i1_{threshold}).

It will be understood that the measurement circuit 156 in the cable assembly 1100 may take any suitable configuration which enable the measurement circuit 156 to determine the current (i_{measured}) across the main lead 3 and auxiliary lead 5. In cable assembly 1100 the measurement circuit 156 comprises an electronic testing module 16, a memory 17 and a processor 18.

The second end portion 3b of the first electrically conductive wire 4 is connected to the measurement circuit 156 at a second node 19 and the second end portion 14b of the second electrically conductive wire 14 is connected to the measurement circuit 156 at a third node 19b. The electronic testing module 16 is electrically connected to the respective second and third nodes 19a,19b.

The electronic testing module 16 is configured so that it can provide the processor 18 with the measured current value (i_{measured}) flowing into the third node 19b and into the main lead 3. As will be described in more detail below, the electronic testing module 16 may comprise a current measuring means configured to, or configurable to, measure the current (I_{measured}) which flows into the third node 19b; the electronic testing module 16 may comprise a current source which is configured to deliver a test current (I_{applied}) to the third node 19b (and thus to the main lead and auxiliary lead); the electronic testing module 16 may comprise a voltage measuring means configured to measure the voltage (V_{measured}) across the second and third nodes 19a,19b (i.e. the voltage across the auxiliary lead 5 and the main lead 3, between the second and third nodes 19a,19b); the electronic testing module 16 may comprise a voltage source configured to apply a test voltage (V_{applied}) across the main lead and auxiliary lead i.e. apply a test voltage across the second and third nodes 19a,19b.

The electronic testing module 16 may be configured such that it can provide the processor 18 with said current measurement (I_{measured}) taken by the current measuring means and/or the level of test current (I_{applied}) which the current source delivered, and/or said measured voltage (V_{measured}) taken by the voltage measuring means, and/or the level of test voltage (V_{applied}) which the voltage source applied.

The processor 18 is operably connected to the electronic testing module 16 so that the processor 18 can receive said current and voltage values from the electronic testing module 16.

The memory 17 of the measurement circuit 156 stores at least a first predefined threshold current value (i1_{threshold}). The processor 18 is also operably connected to the memory 17 so that the processor 18 can receive said stored at least a first predefined threshold current value (i1_{threshold)} from the memory 17.

The processor is further configured to receive said stored first predefined threshold current value (i1_{threshold}) from the memory 17 and to compare said measured current (i_{measured}) with the first predefined threshold current value (i1_{threshold}). If the measured current (i_{measured}) is smaller than the first predefined threshold current value (i1_{threshold}), this indicates that a break has occurred in either the first electrically conductive wire 4 of the main lead 3 or that a break has occurred in the second electrically conductive wire 14 of the auxiliary lead 5.

The processor 18 is configured to issue an alarm if the measured current (i_{measured}) is smaller than the first predefined threshold current value (i1_{threshold}). The alarm may take any suitable form for example the alarm may be a visible alarm signal, e.g. LED, an audible alarm signal, e.g. buzzer, and/or a digital status signal providing information about the health status of the cable assembly, e.g. "main lead broken, replacement is required". Optionally the processor 18 may be further configured to issue an assurance signal e.g. "cable fully intact", if the measured current (i_{measured}) is greater than the first predefined threshold current value (i1_{threshold}). In this example the measurement circuit 156 further comprises an output 21 (the processor 18 is connected to the output; if the processor is to issue an alarm signal it can provide a signal to the output 21 which will generate the alarm); most preferably the measurement circuit 156 will issue an alarm signal at the output 21 if the measured current (i_{measured}) is smaller than the first predefined threshold current value (i1_{threshold}).

The measurement circuit 156 further comprises a main lead contact 23. The main lead contact 23 is connected (or can be selectively connected) to the first electrically conductive wire 4 of the main lead. The main lead contact 23 can output signals which have been transmitted along the main lead 3; most preferably the main lead contact 23 outputs signals which have been transmitted along the main lead 3 from the first end portion 3a of the main lead 3, to the second end portion 3b of the main lead 3, or the main lead contact 23 acts as an input for signals which are to be transmitted along the main lead 3 from the second end portion 3b of the main lead 3, to the first end portion 3a of the main lead 3. Typically, the main lead contact 23 will be further electrically connected to external circuitry, thus signal(s) transmitted along the main lead 23 from the first end portion 3a of the main lead 3, to the second end portion 3b of the main lead 3 can be sent to the external circuitry via the main lead contact 23, or signal(s) received from the external circuitry can be transmitted along the main lead 23 from the second end portion 3b of the main lead 3, to the first end portion 3a of the main lead 3.

Optionally the memory 17 of the measurement circuit 156 may store a second predefined threshold current value (i2_{threshold}). The processor 18 is also operably connected to the memory 17 so that the processor 18 can receive said stored second predefined threshold current value (i2_{threshold}) from the memory 17 (the second predefined threshold current value (i2_{threshold}) being smaller than the first predefined threshold current value (i1_{threshold}). Optionally, the processor 18 is further configured to compare said measured current (i_{measured}) with the second predefined threshold current value (i2_{threshold}) if the measured current (i_{measured}) is smaller than the first predefined threshold current value (i1_{threshold}). If said measured current (i_{measured}) is smaller than both the first predefined threshold current value (i1_{threshold}) and the second predefined threshold current value (i2_{threshold}) this indicates that there is an unacceptable number of breaks in the electrically conductive wire 4 or that there is an unacceptable extent of damage to the first electrically conductive wire 4 and the first electrically conductive sheath 7 of the main lead 3 or that there is a break in the second electrically conductive wire 5 of the auxiliary lead; if said measured current (i_{measured}) is smaller than the first predefined threshold current value (i1_{threshold}) but is less than the second predefined threshold current value (i2_{threshold}) this indicates that there is one or more breaks in the electrically conductive wire 4 (and also possibly some damage to the first electrically conductive sheath 7) of the main lead 3 but that the number of breaks (and extent of damage) is acceptable. Preferably the processor 18 is configured to issue a first alarm if the measured current (i_{measured}) is smaller than the first predefined threshold current value (i1_{threshold}) and the measured current (i_{measured}) is greater than the second predefined threshold current value (i2_{threshold}); and is configured to issue a second alarm (which is preferably different to the first alarm) if the measured current (i_{measured}) is smaller than the first predefined threshold current value (i1_{threshold}) and the measured current (i_{measured}) is smaller than the second predefined threshold current value (i2_{threshold}).

Preferably, the processor 18 is configured to update the first predefined threshold current value (i1_{threshold}) stored in the memory 17, if the measured current (i_{measured}) is smaller than the first predefined threshold current value (i1_{threshold}) and the measured current (i_{measured}) is greater than the second predefined threshold current value (i2_{threshold}). The processor 18 may be configured to update the first predefined threshold current value (i1_{threshold}) to be equal to the "measured current (i_{measured}) - a predefined first current decrease value (i_{dec1})" wherein said predefined first current decrease value (i_{dec1}) is the decrease of the current flowing into the third node 19b which is expected when a break occurs in the first electrically conductive wire 4 of the main lead and a known test voltage (V_{applied}) is applied across the main lead 3 and the auxiliary lead 5, i.e., across the second and third nodes 19a,19b, respectively. The measured current is inversely proportional to resistance and hence inversely proportional to the number of breaks in the first electrically conductive wire 4 and/or the extent of damage to the first electrically conductive sheath 7 of the main lead 3 and/or the extent of damage to the second electrically conductive wire 14; the predefined minimum current i2_{threshold} is the measured current (i_{measured}) when a known test voltage (v_{applied}) is applied across the main lead 3 and the auxiliary lead 5 (i.e., between the second and third nodes 19a,19b) and when the resistance of the main lead 3 and the auxiliary lead 5 has the maximum tolerable value (which in turn reflects how many breaks and how much damage to the main lead is to be tolerated), and i2_{trehshold} can be chosen depending on the application in which the cable assembly is used.

It should be noted that the predefined first current decrease value (i_{dec1}) could be determined in a calibration process using a test lead which is similar to the main lead 3, which involves applying a known test voltage (v_{applied}) to the test lead, measuring a first current flowing through the test lead (unbroken), then providing a break in the conductive wire of the test lead and measuring a second current flowing through the test lead; then subtracting the second measured current from the first measured current to determine the predefined first current decrease value (i_{dec1}).

Figure 17 illustrates one possible implementation for the measurement circuit 156. This example is similar to the measurement circuit 15a shown in Figure 3a, with the main difference that the measured current i_{measured} is compared to a threshold current i_{threshold} in order to detect an increase in the series resistance of the main lead 3 and the auxiliary lead 5 between the second node 19a and the third node 19b. In this example the measurement circuit 15g comprises an electronic testing module 16g which comprises a voltage module 141g which is electrically connected to the second node 19a and also electrically connected to the third node 19b. The voltage module 141g comprises a voltage source which can selectively apply a voltage (v_{applied}) across the main lead 3 and auxiliary lead 5 which are connected in series, i.e. apply the voltage (v_{applied}) across the second and third nodes 19a,19b.

The electronic testing module 16g further comprises a current measurement means 142g which is connected to the third node 19b, so that the current measurement means 142g can measure the current (i_{measured}) flowing into the third node 19b; the measured current (i_{measured}) will flow into the third node 19b, along the main lead 3 and auxiliary lead 5 and into the second node 19a. The current measurement means 142g is configured to measure the current (i_{measured}) flowing into the third node 19b after the voltage source of the voltage module 141g has applied a test voltage (v_{applied}) across the second node 19a and the third node 19b.

Preferably the processor 18 is configured to control the voltage module 141g and the current measurement means 142g; the processor 18 may be configured to initiate the voltage source of the voltage module 141g to apply a test voltage (v_{applied}) across the second node 19a and the third node 19b, and to initiate the current measurement means 142g to measure the current (i_{measured}) (resulting from the test voltage (v_{applied})) flowing into node 19b and hence into the main lead 3.

The processor 18 is configured to receive from the current measurement means 142g said current measurement (i_{measured}) taken by the current measurement means after the voltage source of the voltage module 141g applied the test voltage (v_{applied}). Optionally, the processor 18 may be configured to initiate the voltage source of the voltage module 141g to stop applying a test voltage (v_{applied}) across the second and third nodes 19a,19b, and to initiate the current measurement means 142g to stop measuring current, after the processor has received said current measurement (i_{measured}).

The processor 18 is further configured to receive a current threshold value i_{threshold} from the memory module 17 and to compare the measured current i_{measured} to the current threshold value i_{threshold}. If the measured current i_{measured} is smaller than the current threshold value i_{threshold}, this indicates that a break has occurred in the main lead 3 or in the auxiliary lead 5.

Various modifications and variations to the described embodiments of the invention will be apparent to those skilled in the art without departing from the scope of the invention as defined in the appended claims. Although the invention has been described in connection with specific preferred embodiments, it should be understood that the invention as claimed should not be unduly limited to such specific embodiment.

## Claims

1. A cable assembly (1) comprising,
at least one main lead (3) and at least one auxiliary lead (5) which are connected;
the main lead (3) comprising a first end portion (3a) and a second, opposite end portion (3b), the main lead (3) comprising a first electrically conductive wire (4) having a first electrically conductive sheath (7) which has a first predefined resistance, and wherein the second end portion (3b) of the first electrically conductive wire (4) is configured such that it can be electrically connected to a measurement circuit (15);
the auxiliary lead (5) comprising at least a second electrically conductive wire (14), having a first end (14a) and a second, opposite end (14b), the first end (14a) being connected to the first end portion (3a) of the first electrically conductive wire (4) at a first node (8), and the second end portion (14b) of the second electrically conductive wire (14) is configured such that it can be electrically connected to a measurement circuit (15);
**characterized in that**,
the auxiliary lead (3) comprises a second electrically conductive sheath (107) which surrounds the second electrically conductive wire (14), wherein the second electrically conductive sheath (107) is configured to have a second predefined resistance, wherein the first predefined resistance is different to the second predefined resistance;
and the cable assembly further comprises a measurement circuit (15), the measurement circuit (15) comprising,
an electronic testing module (16), wherein the second end portion (14b) of the second electrically conductive wire (14) is connected to the electronic testing module (16) at a second node (19a), and the second end portion (3b) of the first electrically conductive wire (4) is connected to the electronic testing module (16) at a third node (19b);
a memory (17) which stores at least a first predefined threshold resistance value (R1_{threshold});
a processor (18), which is operably connected to the electronic testing module (16) so that the processor (18) can receive electrical parameters from said electronic testing module (16), and wherein the processor (18) is further operably connected to the memory (17) so that the processor (18) can receive said stored at least a first predefined threshold resistance value (R1_{threshold}) from the memory (17),
and wherein the processor (18) is configured to calculate a measured resistance (R_{measured}) of the main lead (3) between the first node (8) and the third node (19b), or wherein the processor (18) is configured to calculate a measured resistance (R_{measured}) of the main lead (3) and auxiliary lead (5), between the second (19a) and third nodes (19b), using the received electrical parameters;
and wherein the processor (18) is further configured to compare the measured resistance (R_{measured}) with the first predefined threshold resistance value (R1_{threshold});
wherein the memory (17) further stores a second predefined threshold resistance value (R2_{threshold}), and a first predefined resistance change (R_{inc1}) and a second predefined resistance change (R_{inc2}) and a third predefined threshold resistance value (R3_{threshold}); and
wherein the processor (18) is further configured to, compare the measured resistance (R_{measured}) with the second predefined threshold resistance value (R2_{threshold}) if the measured resistance (R_{measured}) is greater than the first predefined threshold resistance value (R1_{threshold}), and to adjust the value of the first predefined threshold resistance value (R1_{threshold}) stored in the memory (17) to be equal to the measured resistance (R_{measured}) plus the first predefined resistance change (R_{inc1}) if the measured resistance (R_{measured}) is greater than the first predefined threshold resistance value (R1_{threshold}) and the measured resistance (R_{measured}) is smaller than the second predefined threshold resistance value (R2_{threshold}), and to adjust the value of the second predefined threshold resistance value (R2_{threshold}) stored in the memory (17) to be equal to the measured resistance (R_{measured}) plus the second predefined resistance change (R_{inc2}), if the measured resistance (R_{measured}) is greater than the first predefined threshold resistance value (R1_{threshold}) and the measured resistance (R_{measured}) is smaller than the second predefined threshold resistance value (R2_{threshold}) and the measured resistance (R_{measured}) is smaller than the third predefined threshold resistance value (R3_{threshold});
and wherein the processor (18) is further configured to compare the measured resistance (R_{measured}) with the third predefined threshold resistance value (R3_{threshold}) if the determined resistance value (R_{measured}) is greater than the first predefined threshold resistance value (R1_{threshold}) and is greater than the second predefined threshold resistance value (R2_{threshold}), and to adjust the value of the first predefined threshold resistance value (R1_{threshold}) stored in the memory (17) to be equal to the measured resistance (R_{measured}) plus the first predefined resistance change (R_{inc1}) and adjust the value of the second predefined threshold resistance value (R2_{threshold}) stored in the memory (17) to be equal to the measured resistance (R_{measured}) plus the second predefined resistance change (R_{inc2})
wherein the processor (18) is further configured to,
determine that there is a break in the first electrically conductive wire (4) of the main lead (3), but that the main lead (3) is still useable, if the measured resistance (R_{measured}) is greater than the first predefined threshold resistance value (R1_{threshold}) but is less than the second predefined threshold resistance value (R2_{threshold}),
determine that there is a break in the second electrically conductive wire (14) of the auxiliary lead (5), but no break in the first electrically conductive wire (4) of the main lead (3), if the measured resistance (R_{measured}) is greater than the first predefined threshold resistance value (R1_{threshold}), and greater than the second predefined threshold resistance value (R2_{threshold}), but is less than the third predefined threshold resistance value (R3_{threshold}),
determine that there is an intolerable number of breaks in the electrically conductive wire (4) of the main lead (3) and/or the electrically conductive wire (14) of the auxiliary lead (5) if the measured resistance (R_{measured}) is greater than the first predefined threshold resistance value (R1_{threshold}), the second predefined threshold resistance value (R2_{threshold}), and the third predefined threshold resistance value (R3_{threshold}).

2. A cable assembly according to claim 1 wherein said main lead (3) and said auxiliary lead (5) are arranged to be side-by-side along the majority of the length of the main lead (3) and auxiliary lead (5).

3. A cable assembly according to any one of the preceding claims, wherein the electronic testing module (16) comprises,
a voltage source arranged such that it can apply a voltage across the main lead (3) and auxiliary lead (5);
and a current measurement means arranged to measure current which flows into the third node (19b);
and wherein said electrical parameters comprise the voltage applied by the voltage source across the main lead (3) and auxiliary lead (5), and the current measured by the current measurement means.

4. A cable assembly according to any one of claim 1-3, wherein the electronic testing module (16) comprises,
a current source which is arranged such that it can supply a current to the third node (19b);
and a voltage measurement means arranged to measure a voltage between the second and third nodes;
and wherein said electrical parameters comprise the current supplied by the current source, and the voltage measured by the voltage measurement means.

5. A cable assembly according to any one of claims 1-3, wherein the measurement circuit (15) comprises,
a current measurement means arranged to measure current which flows into the third node; (19b);
and a voltage measurement means arranged to measure a voltage between the second and third nodes;
and wherein said electrical parameters comprise the current measured by the current measurement means, and the voltage measured by the voltage measurement means.

6. A cable assembly according to claim 5, wherein the processor (18) is further configured to issue an alarm signal if the current measurement (I_{measured}) taken by the current measurement means indicates that there is no current flowing through the third node (19b).

7. A cable assembly according to any one of claims 3-6, wherein the measurement circuit (15) further comprises a main lead contact (23) which is electrically connected to the second node (19a);
wherein the measurement circuit (15) further comprises a first switch (35) which is connected in series with the electronic testing module (16) between the third node (19b) and electronic testing module (16); and
wherein the measurement circuit (15) further comprises a second switch (36) between the third node (19b) and the main lead contact (23).

8. A cable assembly according to any one of the preceding claims, wherein the processor (18) is further configured to issue a first alarm if the measured resistance (R_{measured}) is greater than the first predefined threshold resistance value (R1_{threshold}) and is smaller than the second predefined threshold resistance value (R2_{threshold}); and
wherein the processor (18) is further configured to issue a second alarm if the measured resistance (R_{measured}) is greater than the second predefined threshold resistance value (R2_{threshold}) and is smaller than the third predefined threshold resistance value (R3_{threshold}); and
wherein the processor (18) is further configured to issue a third alarm if the measured resistance (R_{measured}) is greater than the first predefined threshold resistance value (R1_{threshold}), the second predefined threshold resistance value (R2_{threshold}), and the third predefined threshold resistance value (R3_{threshold}).

9. A cable assembly according to any one of the preceding claims, wherein the cable assembly further comprises,
a first plug member (51),
a second plug member (52),
wherein the first electrically conductive wire (4) extends between first plug member (51) and the second plug member (52), a first end portion (3a) of said first electrically conductive wire (4) is connected to a first electrical contact (51a) of the first plug member (51) and a second, opposite, end portion (3b) of said first electrically conductive wire (4) is connected to a first electrical contact (52a) of the second plug member (52), so that said first electrically conductive wire (4) electrically connects the first and second plug members;
and wherein the first node (8) is housed within the first plug member (51); and wherein the second electrically conductive wire (14) extends from the first node (8) to the second plug member (52).

## Patentansprüche

1. Kabelanordnung (1), die Folgendes umfasst:
mindestens eine Hauptleitung (3) und mindestens eine Hilfsleitung (5), die verbunden sind; wobei
die Hauptleitung (3) einen ersten Endabschnitt (3a) und einen gegenüberliegenden zweiten Endabschnitt (3b) umfasst, die Hauptleitung (3) einen ersten elektrisch leitenden Draht (4) umfasst, der einen ersten elektrisch leitenden Mantel (7) besitzt, der einen ersten im Voraus definierten Widerstand besitzt, und der zweite Endabschnitt (3b) des ersten elektrisch leitenden Drahts (4) derart konfiguriert ist, dass er mit einer Messschaltung (15) elektrisch verbunden werden kann; und
die Hilfsleitung (5) mindestens einen zweiten elektrisch leitenden Draht (14) umfasst, der ein erstes Ende (14a) und ein gegenüberliegendes zweites Ende (14b) besitzt, wobei das erste Ende (14a) mit dem ersten Endabschnitt (3a) des ersten elektrisch leitenden Drahts (4) bei einem ersten Knoten (8) verbunden ist und der zweite Endabschnitt (14b) des zweiten elektrisch leitenden Drahts (14) derart konfiguriert ist, dass er mit einer Messschaltung (15) elektrisch verbunden werden kann;
**dadurch gekennzeichnet, dass**
die Hilfsleitung (3) einen zweiten elektrisch leitenden Mantel (107) umfasst, der den zweiten elektrisch leitenden Draht (14) umgibt, wobei der zweite elektrisch leitende Mantel (107) konfiguriert ist, einen zweiten im Voraus definierten Widerstand zu besitzen, wobei der erste im Voraus definierte Widerstand vom zweiten im Voraus definierten Widerstand verschieden ist; und
die Kabelanordnung ferner eine Messschaltung (15) umfasst, wobei die Messschaltung (15) Folgendes umfasst:
ein elektronisches Prüfmodul (16), wobei der zweite Endabschnitt (14b) des zweiten elektrisch leitenden Drahts (14) bei einem zweiten Knoten (19a) mit dem elektronischen Prüfmodul (16) verbunden ist und der zweite Endabschnitt (3b) des ersten elektrisch leitenden Drahts (4) bei einem dritten Knoten (19b) mit dem elektronischen Prüfmodul (16) verbunden ist;
einen Speicher (17), in dem mindestens ein erster im Voraus definierter Schwellenwertwiderstandswert (R1_{threshold}) gespeichert ist;
einen Prozessor (18), der mit dem elektronischen Prüfmodul (16) betriebstechnisch verbunden ist, derart, dass der Prozessor (18) elektrische Parameter vom elektronischen Prüfmodul (16) empfangen kann, wobei der Prozessor (18) ferner mit dem Speicher (17) betriebstechnisch verbunden ist, derart, dass der Prozessor (18) den gespeicherten mindestens einen ersten im Voraus definierten Schwellenwertwiderstandswert (R1_{threshold}) vom Speicher (17) empfangen kann,
der Prozessor (18) konfiguriert ist, einen gemessenen Widerstand (R_{measured}) der Hauptleitung (3) zwischen dem ersten Knoten (8) und dem dritten Knoten (19b) zu berechnen, oder der Prozessor (18) konfiguriert ist, einen gemessenen Widerstand (R_{measured}) der Hauptleitung (3) und der Hilfsleitung (5) zwischen dem zweiten Knoten (19a) und dem dritten Knoten (19b) unter Verwendung der empfangenen elektrischen Parameter zu berechnen;
der Prozessor (18) ferner konfiguriert ist, den gemessenen Widerstand (R_{measured}) mit dem ersten im Voraus definierten Schwellenwertwiderstandswert (R1_{threshold}) zu vergleichen;
im Speicher (17) ferner ein zweiter im Voraus definierter Schwellenwertwiderstandswert (R2_{threshold}), eine erste im Voraus definierte Widerstandsänderung (R_{inc1}), eine zweite im Voraus definierte Widerstandsänderung (R_{inc2}) und ein dritter im Voraus definierter Schwellenwertwiderstandswert (R3_{threshold}) gespeichert sind;
der Prozessor (18) ferner konfiguriert ist, den gemessenen Widerstand (R_{measured}) mit dem zweiten im Voraus definierten Schwellenwertwiderstandswert (R2_{threshold})zu vergleichen, wenn der gemessene Widerstand (R_{measured}) größer als der erste im Voraus definierte Schwellenwertwiderstandswert (R1_{threshold}) ist, und den Wert des ersten im Voraus definierten Schwellenwertwiderstandswerts (R1_{threshold}), der im Speicher (17) gespeichert ist, derart anzupassen, dass er gleich dem gemessenen Widerstand (R_{measured}) plus die erste im Voraus definierte Widerstandsänderung (R_{inc1}) ist, wenn der gemessene Widerstand (R_{measured}) größer als der erste im Voraus definierte Schwellenwertwiderstandswert (R1_{threshold}) ist und der gemessene Widerstand (R_{measured}) kleiner als der zweite im Voraus definierte Schwellenwertwiderstandswert (R2_{threshold}) ist, und den Wert des zweiten im Voraus definierten Schwellenwertwiderstandswerts (R2_{threshold}), der im Speicher (17) gespeichert ist, derart anzupassen, dass er gleich dem gemessenen Widerstand (R_{measured}) plus die zweite im Voraus definierte Widerstandsänderung (R_{inc2}) ist, wenn der gemessene Widerstand (R_{measured}) größer als der erste im Voraus definierte Schwellenwertwiderstandswert (R1_{threshold}) ist und der gemessene Widerstand (R_{measured}) kleiner als der zweite im Voraus definierte Schwellenwertwiderstandswert (R2_{threshold}) ist und der gemessene Widerstand (R_{measured}) kleiner als der dritte im Voraus definierte Schwellenwertwiderstandswert (R3_{threshold}) ist; und
der Prozessor (18) ferner konfiguriert ist, den gemessenen Widerstand (R_{measured}) mit dem dritten im Voraus definierten Schwellenwertwiderstandswert (R3_{threshold}) zu vergleichen, wenn der bestimmte Widerstandswert (R_{measured}) größer als der erste im Voraus definierte Schwellenwertwiderstandswert (R1_{threshold}) ist und größer als der zweite im Voraus definierte Schwellenwertwiderstandswert (R2_{threshold}) ist, und den Wert des ersten im Voraus definierten Schwellenwertwiderstandswerts (R1_{threshold}), der im Speicher (17) gespeichert ist, derart anzupassen, dass er gleich dem gemessenen Widerstand (R_{measured}) plus die erste im Voraus definierte Widerstandsänderung (R_{inc1}) ist, und den Wert des zweiten im Voraus definierten Schwellenwertwiderstandswerts (R2_{threshold}), der im Speicher (17) gespeichert ist, derart anzupassen, dass er gleich dem gemessenen Widerstand (R_{measured}) plus die zweite im Voraus definierte Widerstandsänderung (R_{inc2}) ist; wobei
der Prozessor (18) ferner konfiguriert ist zum
Bestimmen, dass ein Bruch im ersten elektrisch leitenden Draht (4) der Hauptleitung (3) vorliegt, dass jedoch die Hauptleitung (3) immer noch verwendbar ist, wenn der gemessene Widerstand (R_{measured}) größer als der erste im Voraus definierte Schwellenwertwiderstandswert (R1_{threshold}) ist, jedoch kleiner als der zweite im Voraus definierte Schwellenwertwiderstandswert (R2_{threshold}) ist,
Bestimmen, dass ein Bruch im zweiten elektrisch leitenden Draht (14) der Hilfsleitung (5) vorliegt, dass jedoch kein Bruch im ersten elektrisch leitenden Draht (4) der Hauptleitung (3) vorliegt, wenn der gemessene Widerstand (R_{measured}) größer als der erste im Voraus definierte Schwellenwertwiderstandswert (R1_{threshold}) ist und größer als der zweite im Voraus definierte Schwellenwertwiderstandswert (R2_{threshold}) ist, jedoch kleiner als der dritte im Voraus definierte Schwellenwertwiderstandswert (R3_{threshold}) ist, und
Bestimmen, dass eine untragbare Anzahl von Brücken im elektrisch leitenden Draht (4) der Hauptleitung (3) und/oder im elektrisch leitenden Draht (14) der Hilfsleitung (5) vorliegt, wenn der gemessene Widerstand (R_{measured}) größer als der erste im Voraus definierte Schwellenwertwiderstandswert (R1_{threshold}), der zweite im Voraus definierte Schwellenwertwiderstandswert (R2_{threshold}) und der dritte im Voraus definierte Schwellenwertwiderstandswert (R3_{threshold}) ist.

2. Kabelanordnung nach Anspruch 1, wobei die Hauptleitung (3) und die Hilfsleitung (5) über den Hauptteil der Länge der Hauptleitung (3) und der Hilfsleitung (5) nebeneinander angeordnet sind.

3. Kabelanordnung nach einem der vorhergehenden Ansprüche, wobei das elektronische Prüfmodul (16) Folgendes umfasst:
eine Spannungsquelle, die derart ausgelegt ist, dass sie eine Spannung über die Hauptleitung (3) und die Hilfsleitung (5) anlegen kann; und
ein Strommessmittel, das ausgelegt ist, Strom, der in den dritten Knoten (19b) fließt, zu messen; wobei
die elektrischen Parameter die Spannung, die durch die Spannungsquelle über die Hauptleitung (3) und die Hilfsleitung (5) angelegt wird, und den Strom, der durch das Strommessmittel gemessen wird, umfassen.

4. Kabelanordnung nach einem der vorhergehenden Ansprüche 1-3, wobei das elektronische Prüfmodul (16) Folgendes umfasst:
eine Stromquelle, die derart ausgelegt ist, dass sie einen Strom zum dritten Knoten (19b) liefern kann; und
ein Spannungsmessmittel, das ausgelegt ist, eine Spannung zwischen dem zweiten und dem dritten Knoten zu messen; wobei
die elektrischen Parameter den Strom, der durch die Stromquelle geliefert wird, und die Spannung, die durch das Spannungsmessmittel gemessen wird, umfassen.

5. Kabelanordnung nach einem der vorhergehenden Ansprüche 1-3, wobei die Messschaltung (15) Folgendes umfasst:
ein Strommessmittel, das ausgelegt ist, Strom, der in den dritten Knoten (19b) fließt, zu messen; und
ein Spannungsmessmittel, das ausgelegt ist, eine Spannung zwischen dem zweiten und dem dritten Knoten zu messen; wobei
die elektrischen Parameter den Strom, der durch das Strommessmittel gemessen wird, und die Spannung, die durch das Spannungsmessmittel gemessen wird, umfassen.

6. Kabelanordnung nach Anspruch 5, wobei der Prozessor (18) ferner konfiguriert ist, ein Alarmsignal auszugeben, wenn der Strommesswert (I_{measured}), der durch das Strommessmittel aufgenommen wird, anzeigt, dass kein Strom durch den dritten Knoten (19b) fließt.

7. Kabelanordnung nach einem der vorhergehenden Ansprüche 3-6, wobei
die Messschaltung (15) ferner einen Hauptleiterkontakt (23), der mit dem zweiten Knoten (19a) elektrisch verbunden ist, umfasst;
die Messschaltung (15) ferner einen ersten Schalter (35) umfasst, der zwischen dem dritten Knoten (19b) und dem elektronischen Prüfmodul (16) mit dem elektronischen Prüfmodul (16) in Reihe geschaltet ist; und
die Messschaltung (15) ferner einen zweiten Schalter (36) zwischen dem dritten Knoten (19b) und dem Hauptleiterkontakt (23) umfasst.

8. Kabelanordnung nach einem der vorhergehenden Ansprüche, wobei der Prozessor (18) ferner konfiguriert ist, einen ersten Alarm auszugeben, wenn der gemessene Widerstand (R_{measured}) größer als der erste im Voraus definierte Schwellenwertwiderstandswert (R1_{threshold}) ist und kleiner als der zweite im Voraus definierte Schwellenwertwiderstandswert (R2_{threshold}) ist;
der Prozessor (18) ferner konfiguriert ist, einen zweiten Alarm auszugeben, wenn der gemessene Widerstand (R_{measured}) größer als der zweite im Voraus definierte Schwellenwertwiderstandswert (R2_{threshold}) ist und kleiner als der dritte im Voraus definierte Schwellenwertwiderstandswert (R3_{threshold}) ist; und
der Prozessor (18) ferner konfiguriert ist, einen dritten Alarm auszugeben, wenn der gemessene Widerstand (R_{measured}) größer als der erste im Voraus definierte Schwellenwertwiderstandswert (R1_{threshold}), der zweite im Voraus definierte Schwellenwertwiderstandswert (R2_{threshold}) und der dritte im Voraus definierte Schwellenwertwiderstandswert (R3_{threshold}) ist.

9. Kabelanordnung nach einem der vorhergehenden Ansprüche, wobei die Kabelanordnung ferner Folgendes umfasst:
ein erstes Steckelement (51) und
ein zweites Steckelement (52), wobei
der erste elektrisch leitende Draht (4) zwischen dem ersten Steckelement (51) und dem zweiten Steckelement (52) verläuft, ein erster Endabschnitt (3a) des ersten elektrisch leitenden Drahts (4) mit einem ersten elektrischen Kontakt (51a) des ersten Steckelements (51) verbunden ist und ein gegenüberliegender zweiter Endabschnitt (3b) des ersten elektrisch leitenden Drahts (4) mit einem ersten elektrischen Kontakt (52a) des zweiten Steckelements (52) verbunden ist, derart, dass der erste elektrisch leitende Draht (4) das erste und das zweite Steckelement elektrisch verbindet;
der erste Knoten (8) im ersten Steckelement (51) untergebracht ist und
der zweite elektrisch leitende Draht (14) vom ersten Knoten (8) zum zweiten Steckelement (52) verläuft.

## Revendications

1. Ensemble câble (1), comprenant,
au moins un conducteur principal (3) et au moins un conducteur auxiliaire (5) qui sont reliés ;
le conducteur principal (3) comprenant une première portion extrémité (3a) et une deuxième portion extrémité opposée (3b), le conducteur principal (3) comprenant un premier fil électriquement conducteur (4) possédant une première gaine électriquement conductrice (7) qui possède une première résistance prédéfinie, et la deuxième portion extrémité (3b) du premier fil électriquement conducteur (4) étant configurée de sorte à pouvoir être reliée électriquement à un circuit de mesure (15) ;
le conducteur auxiliaire (5) comprenant au moins un deuxième fil électriquement conducteur (14), possédant une première extrémité (14a) et une deuxième extrémité opposée (14b), la première extrémité (14a) étant reliée à la première portion extrémité (3a) du premier fil électriquement conducteur (4) au niveau d'un premier nœud (8) et la deuxième portion extrémité (14b) du deuxième fil électriquement conducteur (14) étant configurée de sorte à pouvoir être reliée électriquement à un circuit de mesure (15) ;
**caractérisé en ce que**,
le conducteur auxiliaire (3) comprend une deuxième gaine électriquement conductrice (107) qui entoure le deuxième fil électriquement conducteur (14), la deuxième gaine électriquement conductrice (107) étant configurée de manière à posséder une deuxième résistance prédéfinie, la première résistance prédéfinie étant différente de la deuxième résistance prédéfinie ;
et l'ensemble câble comprend en outre un circuit de mesure (15), le circuit de mesure (15) comprenant,
un module de test électronique (16), la deuxième portion extrémité (14b) du deuxième fil électriquement conducteur (14) étant reliée au module de test électronique (16) au niveau d'un deuxième nœud (19a) et la deuxième portion extrémité (3b) du premier fil électriquement conducteur (4) étant reliée au module de test électronique (16) au niveau d'un troisième nœud (19b) ;
une mémoire (17) qui stocke au moins une première valeur de résistance seuil prédéfinie (R1_{threshold}) ;
un processeur (18) qui est relié fonctionnellement au module de test électronique (16) de façon à ce que le processeur (18) puisse recevoir des paramètres électriques depuis ledit module de test électronique (16), et le processeur (18) étant en outre relié fonctionnellement à la mémoire (17) de façon à ce que le processeur (18) puisse recevoir ladite au moins une valeur de résistance seuil prédéfinie (R1_{threshold}) stockée depuis la mémoire (17),
et le processeur (18) étant configuré pour calculer une résistance mesurée (R_{measured}) du conducteur principal (3) entre le premier nœud (8) et le troisième nœud (19b), ou le processeur (18) étant configuré pour calculer une résistance mesurée (R_{measured}) du conducteur principal (3) et du conducteur auxiliaire (5) entre le deuxième nœud (19a) et le troisième nœud (19b) au moyen des paramètres électriques reçus ;
et le processeur (18) étant configuré en outre pour comparer la résistance mesurée (R_{measured}) à la première valeur de résistance seuil prédéfinie (R1_{threshold}) ;
la mémoire (17) stockant en outre une deuxième valeur de résistance seuil prédéfinie (R2_{threshold}) et une première variation de résistance prédéfinie (R_{inc1}) et une deuxième variation de résistance prédéfinie (R_{inc2}) et une troisième valeur de résistance seuil prédéfinie (R3_{threshold}) ; et
le processeur (18) étant configuré en outre pour comparer la résistance mesurée (R_{measured}) à la deuxième valeur de résistance seuil prédéfinie (R2_{threshold}) si la résistance mesurée (R_{measured}) est supérieure à la première valeur de résistance seuil prédéfinie (R1_{threshold}), et pour ajuster la valeur de la première valeur de résistance seuil prédéfinie (R1_{threshold}) stockée dans la mémoire (17) pour la rendre égale à la résistance mesurée (R_{measured}) majorée de la première variation de résistance prédéfinie (R_{inc1}) si la résistance mesurée (R_{measured}) est supérieure à la première valeur de résistance seuil prédéfinie (R1_{threshold}) et la résistance mesurée (R_{measured}) est inférieure à la deuxième valeur de résistance seuil prédéfinie (R2_{threshold}), et pour ajuster la valeur de la deuxième valeur de résistance seuil prédéfinie (R2_{threshold}) stockée dans la mémoire (17) pour la rendre égale à la résistance mesurée (R_{measured}) majorée de la deuxième variation de résistance prédéfinie (R_{inc2}) si la résistance mesurée (R_{measured}) est supérieure à la première valeur de résistance seuil prédéfinie (R1_{threshold}) et la résistance mesurée (R_{measured}) est inférieure à la deuxième valeur de résistance seuil prédéfinie (R2_{threshold}) et la résistance mesurée (R_{measured}) est inférieure à la troisième valeur de résistance seuil prédéfinie (R3_{threshold}) ;
et le processeur (18) étant configuré en outre pour comparer la résistance mesurée (R_{measured}) à la troisième valeur de résistance seuil prédéfinie (R3_{threshold}) si la valeur de résistance déterminée (R_{measured}) est supérieure à la première valeur de résistance seuil prédéfinie (R1_{threshold}) et est supérieure à la deuxième valeur de résistance seuil prédéfinie (R2_{threshold}), et pour ajuster la valeur de la première valeur de résistance seuil prédéfinie (R1_{threshold}) stockée dans la mémoire (17) pour la rendre égale à la résistance mesurée (R_{measured}) majorée de la première variation de résistance prédéfinie (R_{inc1}) et ajuster la valeur de la deuxième valeur de résistance seuil prédéfinie (R2_{threshold}) stockée dans la mémoire (17) pour la rendre égale à la résistance mesurée (R_{measured}) majorée de la deuxième variation de résistance prédéfinie ( R_{inc2}),
le processeur (18) étant configuré en outre pour, déterminer qu'il y a une rupture dans le premier fil électriquement conducteur (4) du conducteur principal (3) mais que le conducteur principal (3) est toujours utilisable si la résistance mesurée (R_{measured}) est supérieure à la première valeur de résistance seuil prédéfinie (R1_{threshold}) mais est inférieure à la deuxième valeur de résistance seuil prédéfinie (R2_{threshold}),
déterminer qu'il y a une rupture dans le deuxième fil électriquement conducteur (14) du conducteur auxiliaire (5) mais qu'il n'y a pas de rupture dans le premier fil électriquement conducteur (4) du conducteur principal (3) si la résistance mesurée (R_{measured}) est supérieure à la première valeur de résistance seuil prédéfinie (R1_{threshold}) et supérieure à la deuxième valeur de résistance seuil prédéfinie (R2_{threshold}) mais est inférieure à la troisième valeur de résistance seuil prédéfinie (R3_{threshold}),
déterminer qu'il y a un nombre inacceptable de ruptures dans le fil électriquement conducteur (4) du conducteur principal (3) et/ou le fil électriquement conducteur (14) du conducteur auxiliaire (5) si la résistance mesurée (R_{measured}) est supérieure à la première valeur de résistance seuil prédéfinie (R1_{threshold}), à la deuxième valeur de résistance seuil prédéfinie (R2_{threshold}) et à la troisième valeur de résistance seuil prédéfinie ( R3_{threshold}).

2. Ensemble câble selon la revendication 1, dans lequel ledit conducteur principal (3) et ledit conducteur auxiliaire (5) sont agencés côte à côte sur la plus grande partie de la longueur du conducteur principal (3) et du conducteur auxiliaire (5).

3. Ensemble câble selon l'une quelconque des revendications précédentes, dans lequel le module de test électronique (16) comprend,
une source de tension agencée de sorte à pouvoir appliquer une tension aux bornes du conducteur principal (3) et du conducteur auxiliaire (5) ;
et un moyen de mesure de courant agencé pour mesurer un courant passant dans le troisième nœud (19b) ;
et dans lequel lesdits paramètres électriques comprennent la tension appliquée par la source de tension aux bornes du conducteur principal (3) et du conducteur auxiliaire (5) et le courant mesuré par le moyen de mesure de courant.

4. Ensemble câble selon l'une quelconque des revendications 1 à 3, dans lequel le module de test électronique (16) comprend,
une source de courant agencée de sorte à pouvoir fournir un courant au troisième nœud (19b) ;
et un moyen de mesure de courant agencé pour mesurer une tension entre les deuxième et troisième nœuds ;
et dans lequel lesdits paramètres électriques comprennent le courant fourni par la source de courant et la tension mesurée par le moyen de mesure de tension.

5. Ensemble câble selon l'une quelconque des revendications 1 à 3, dans lequel le circuit de mesure (15) comprend,
un moyen de mesure de courant agencé pour mesurer un courant passant dans le troisième nœud (19b) ;
et un moyen de mesure de tension agencé pour mesurer une tension entre les deuxième et troisième nœuds ;
et dans lequel lesdits paramètres électriques comprennent le courant mesuré par le moyen de mesure de courant et la tension mesurée par le moyen de mesure de tension.

6. Ensemble câble selon la revendication 5, dans lequel le processeur (18) est configuré en outre pour émettre un signal d'alarme si la mesure de courant (I_{measured}) prise par le moyen de mesure de courant indique l'absence de passage de courant à travers le troisième nœud (19b).

7. Ensemble câble selon l'une quelconque des revendications 3 à 6, dans lequel le circuit de mesure (15) comprend en outre un contact de conducteur principal (23) qui est relié électriquement au deuxième nœud (19a) ;
dans lequel le circuit de mesure (15) comprend en outre un premier interrupteur (35) qui est relié en série avec le module de test électronique (16) entre le troisième nœud (19b) et le module de test électronique (16) ; et
dans lequel le circuit de mesure (15) comprend en outre un deuxième interrupteur (36) entre le troisième nœud (19b) et le contact de conducteur principal (23).

8. Ensemble câble selon l'une quelconque des revendications précédentes, dans lequel le processeur (18) est configuré en outre pour émettre une première alarme si la résistance mesurée (R_{measured}) est supérieure à la première valeur de résistance seuil prédéfinie (R1_{threshold}) et est inférieure à la deuxième valeur de résistance seuil prédéfinie (R2_{threshold}); et
dans lequel le processeur (18) est configuré en outre pour émettre une deuxième alarme si la résistance mesurée (R_{measured}) est supérieure à la deuxième valeur de résistance seuil prédéfinie (R2_{threshold}) et est inférieure à la troisième valeur de résistance seuil prédéfinie (R3_{threshold}) ; et
dans lequel le processeur (18) est configuré en outre pour émettre une troisième alarme si la résistance mesurée (R_{measured}) est supérieure à la première valeur de résistance seuil prédéfinie (R1_{threshold}), à la deuxième valeur de résistance seuil prédéfinie (R2_{threshold}) et à la troisième valeur de résistance seuil prédéfinie (R3_{threshold}).

9. Ensemble câble selon l'une quelconque des revendications précédentes, lequel ensemble câble comprend en outre,
un premier élément fiche (51),
un deuxième élément fiche (52),
dans lequel le premier fil électriquement conducteur (4) s'étend entre le premier élément fiche (51) et le deuxième élément fiche (52), une première portion extrémité (3a) dudit premier fil électriquement conducteur (4) est reliée à un premier contact électrique (51a) du premier élément fiche (51) et une deuxième portion extrémité opposée (3b) dudit premier fil électriquement conducteur (4) est reliée à un premier contact électrique (52a) du deuxième élément fiche (52), de sorte que ledit premier fil électriquement conducteur (4) relie électriquement les premier et deuxième éléments fiches ;
et dans lequel le premier nœud (8) est logé à l'intérieur du premier élément fiche (51) ;
et dans lequel le deuxième fil électriquement conducteur (14) s'étend du premier nœud (8) jusqu'au deuxième élément fiche (52).
